# EUROPEAN PATENT APPLICATION

(11) **EP 4 685 779 A1**
(43) Date of publication of application: **28.01.2026**
(21) Application number: 25185511.0
(22) Date of filing: 26.06.2025
(51) Int. Cl.: G09G 3/32

(54) **DISPLAY DEVICE**

(30) Priority: 26.07.2024 KR 20240099804
(71) Applicant: LG Display Co., Ltd., Seoul, 07336 (KR)
(72) Inventor: KIM, Youngjin, 10845 Paju-si (KR)
(74) Representative: Poll, Christopher

(57) **Abstract**

The present disclosure is a display device. The display device includes a substrate including a display area and a non-display area; a pixel driving circuit disposed on the substrate in the display area; a plurality of light-emitting elements electrically connected to the pixel driving circuit; and a plurality of anode lines extending in a column direction and arranged in a row direction, wherein each of the anode line connects anode electrodes of light-emitting elements arranged so as to be adjacent to each other in the column direction among the plurality of light-emitting elements, wherein each of some of the plurality of anode lines spaced apart from the pixel driving circuit by a predetermined distance in the row direction is repeatedly bent in a zigzag manner and extends along the column direction.

## Description

### TECHNICAL FIELD

The present disclosure relates to a display device.

### BACKGROUND

Display devices are applied to various electronic devices such as TV, mobile phones, laptops, and tablets.

The display device includes an organic light-emitting display device (OLED) that emits light by itself, and a liquid crystal display device (LCD) that requires a separate light source.

Recently, a display device including an light-emitting diode (LED) made of not an organic material but an inorganic material has attracted attention as a next-generation display device. Since the light-emitting diode is made of the inorganic material rather than the organic material, the display device including the light-emitting diode may have a faster lighting speed than that of the liquid crystal display device or the organic light-emitting display device, and may have excellent luminous efficiency, and may display an image with high luminance.

### SUMMARY

In this regard, each light-emitting element made of the inorganic material may be disposed in a display area (Active Area: AA). The light-emitting elements adjacent to each other in a column direction in the display area AA are connected to each other through an anode line.

However, an anode line that applies an anode voltage to each light-emitting element generates parasitic capacitance due to capacitive coupling with a metal line disposed in a different layer from a layer of the anode line. These anode lines are arranged so as to be spaced from each other by a regular spacing along a row direction in the display area, and the density thereof is high in a central area, so that a capacitance in the central area is different from a capacitance of each of other areas than the central area.

Therefore, during a low-gray light emission operation of the light-emitting elements, a difference between luminance of the central area and luminance of a peripheral area may occur due to the difference between the capacitances of the central and peripheral areas, and accordingly, a column line mura may occur.

In order to solve the above-mentioned problem, the inventor of the present disclosure has invented a display device that prevents a difference between luminance of the central area and luminance of the peripheral area during the low-gray light emission operation of the light-emitting elements in the display area.

Thus, a technical purpose according to an implementation of the present disclosure is to provide a display device that prevents a difference between respective capacitance values generated between the respective anode lines and the metal lines or signal lines from occurring during a low grayscale light emission operation of the light-emitting elements in a display area.

In addition, a technical purpose according to an implementation of the present disclosure is to provide a display device in which the anode line generating a capacitance value different from an average capacitance value during the low-gray light emission operation of the light-emitting elements in the display area is repeatedly bent in a zigzag manner and extends along the column direction so as to repeatedly overlap the metal or signal line adjacent thereto, such that each time the anode line is bent, each capacitor may be generated between each bent portion thereof and each portion of the metal or signal line overlapping therewith, and thus, the total capacitance which each of the plurality of anode lines may generate may be substantially equal to the average capacitance value.

Purposes according to the present disclosure are not limited to the above-mentioned purpose. Other purposes and advantages according to the present disclosure that are not mentioned may be understood based on following descriptions, and may be more clearly understood based on implementations according to the present disclosure. Further, it will be easily understood that the purposes and advantages according to the present disclosure may be realized using means shown in the claims or combinations thereof.

A display device according to implementations of the present disclosure may include a substrate including a display area and a non-display area; a pixel driving circuit disposed on the display area of the substrate; a plurality of light-emitting elements disposed on the display area of the substrate, wherein the plurality of light-emitting elements are electrically connected to the pixel driving circuit; and a plurality of anode lines extending in a column direction and arranged in a row direction, wherein each anode line connects anode electrodes of light-emitting elements arranged so as to be adjacent to each other in the column direction among the plurality of light-emitting elements to each other, wherein each of some of the plurality of anode lines spaced apart from the pixel driving circuit by a predetermined distance in the row direction is repeatedly bent in a zigzag manner and extends along the column direction.

A display device according to implementations of the present disclosure may include a substrate; a pixel driving circuit disposed on the substrate; a plurality of light-emitting elements electrically connected to the pixel driving circuit, wherein the plurality of light-emitting elements and the pixel driving circuit are disposed in different layers; an optical insulating layer covering the plurality of light-emitting elements; a first electrode disposed under each of the plurality of light-emitting elements; a second electrode disposed on the plurality of light-emitting elements and the optical insulating layer; and a plurality of anode lines extending in a column direction and arranged in a row direction, wherein each anode line connects anode electrodes of light-emitting elements arranged so as to be adjacent to each other in the column direction among the plurality of light-emitting elements to each other, wherein the plurality of anode lines are arranged so as to be spaced from each other by an equal spacing in the row direction, wherein the plurality of anode lines includes an outermost anode line spaced from the pixel driving circuit by a greatest spacing in the row direction, and a central anode line positioned at a central position of the pixel driving circuit, wherein each of the plurality of anode lines including the outermost anode line to the central anode line arranged so as to be spaced from each other by the equal spacing in the row direction is repeatedly bent in a zigzag manner and extends along the column direction. An exemplary display device of the present disclosure comprises: a display panel including a display area and a non-display area; wherein the display panel comprises: a pixel driving circuit disposed in the display area; a plurality of light-emitting elements electrically connected to the pixel driving circuit; and a plurality of anode lines extending in a column direction and arranged in a row direction; wherein each of the plurality of anode lines connects anode electrodes of light-emitting elements adjacent to the anode line in the column direction among the plurality of light-emitting elements; and each of some of the plurality of anode lines, spaced apart from the pixel driving circuit in the row direction comprises a plurality of segments, each segment comprising a bending segment bent to the row direction, and an extending segment extending along the column direction and directly connected to the bending segment. Two neighboring segments of the plurality of segments are connected to each other such that the anode line extends along the column direction. A first bending segment of a first segment in the two neighboring segments is bent in the row direction such that a second extension segment, of a second segment in the two neighboring segments, connected to the first bending segment overlaps with a metal line of a neighbor layer.

According to an implementation of the present disclosure, the difference between the capacitances between the respective anode lines and the metal or signal line in the display area may be suppressed.

According to an implementation of the present disclosure, the display device capable of preventing the mura from being visually recognized by the user by preventing the capacitance difference from occurring in the low grayscale light-emission operation of the light-emitting elements in a display area may be realized.

According to an implementation of the present disclosure, the difference between the capacitances between the lines for the light-emitting elements in the display area is canceled to prevent the mura from being recognized, thereby preventing a luminance variation during a light-emitting operation.

According to an implementation of the present disclosure, the display device may reduce the power consumption for the light emission by preventing the luminance variation of the display area.

According to an implementation of the present disclosure, as the power consumption of the light-emitting element is reduced, decrease in the lifespan of the display device may be prevented.

In addition, according to an implementation of the present disclosure, a display device capable of reducing the power consumption of the light-emitting element to increase the lifespan of the display panel and of improving the quality of the display device may be provided.

Furthermore, according to an implementation of the present disclosure, a display device capable of securing product reliability by improving the luminance variation of the light-emitting elements may be provided.

According to an implementation of the present disclosure, the power consumption of the light-emitting element is reduced, and decrease in the lifespan of the display device is prevented, thereby providing a long-lifespan and low power consuming display device.

According to an implementation of the present disclosure, as the power consumption of the light-emitting element is reduced, the decrease in the lifespan of the display panel may be reduced, and quality improvement of the display device may be implemented.

Effects of the present disclosure are not limited to the effects mentioned above, and other effects not mentioned will be clearly understood by those skilled in the art from the description as set forth below.

In addition to the above effects, specific effects of the present disclosure are described together while describing specific details for carrying out the present disclosure.

### BRIEF DESCRIPTION OF DRAWINGS

FIG. 1 is an exploded perspective view of a display device according to an implementation of the present disclosure.
FIG. 2 is a plan view of a display device according to an implementation of the present disclosure.
FIG. 3 is an enlarged view of a display device according to an implementation of the present disclosure.
FIG. 4 is a diagram illustrating a circuit structure according to an implementation of the present disclosure.
FIG. 5 is a plan view of a display device according to an implementation of the present disclosure.
FIG. 6 is a plan view of a display device according to an implementation of the present disclosure.
FIG. 7 is a plan view of a display device according to an implementation of the present disclosure.
FIG. 8 is a cross-sectional view of a display device according to an implementation of the present disclosure.
FIG. 9 is a cross-sectional view of a display device according to an implementation of the present disclosure.
FIGS. 10 to 13 are diagrams illustrating an apparatus to which a display device according to implementations of the present disclosure is applied.
FIG. 14 is a plan view illustrating an area in which one pixel driving circuit among a plurality of pixel driving circuits is disposed.
FIG. 15 is a plan view schematically illustrating a configuration of a display device according to a first implementation of the present disclosure.
FIG. 16 is a plan view schematically showing an arrangement structure of a driving chip and anode lines in the display device according to the first implementation of the present disclosure.
FIG. 17 is a cross-sectional view showing a capacitor structure formed between each of the anode lines and a metal line in the display device according to the first implementation of the present disclosure.
FIGS. 18 to 20 are diagrams illustrating an example in which a driving chip controls a light-emitting operation of a light-emitting element in an PWM manner according to an implementation of the present disclosure.
FIG. 21 is a signal waveform diagram illustrating an PWM signal according to an implementation of the present disclosure.
FIG. 22 is a plan view of a display device according to another implementation of the present disclosure.
FIG. 23 is a diagram illustrating a touch operation of a display device according to another implementation of the present disclosure.
FIG. 24 illustrates an example of a signal waveform diagram when a display device according to an implementation of the present disclosure operates.

### DETAILED DESCRIPTION

Advantages and features of the present disclosure, and a method of achieving the advantages and features will become apparent with reference to implementations described below in detail together with the accompanying drawings. However, the present disclosure is not limited to the implementations as disclosed under, but may be implemented in various different forms. Thus, these implementations are set forth only to make the present disclosure complete, and to entirely inform the scope of the present disclosure to those of ordinary skill in the technical field to which the present disclosure belongs, and the present disclosure is only defined by the scope of the claims.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various implementations are illustrated and described further below. It will be understood that the description herein is not intended to limit the claims to the specific implementations described. On the contrary, it is intended to cover alternatives, modifications, and equivalents as may be included within the spirit and scope of the present disclosure as defined by the appended claims.

A shape, a size, a ratio, an angle, a number, etc. disclosed in the drawings for illustrating implementations of the present disclosure are illustrative, and the present disclosure is not limited thereto.

The terminology used herein is directed to the purpose of describing particular implementations only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in the present disclosure, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items.

Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when a first element or layer is referred to as being "connected to", or "coupled to" a second element or layer, the first element may be directly connected to or coupled to the second element or layer, or one or more intervening elements or layers may be present therebetween. In addition, it will also be understood that when an element or layer is referred to as being "between" two elements or layers, it may be the only element or layer between the two elements or layers, or one or more intervening elements or layers may also be present therebetween.

Further, as used herein, when a layer, film, area, plate, or the like is disposed "on" or "on a top" of another layer, film, area, plate, or the like, the former may directly contact the latter or still another layer, film, area, plate, or the like may be disposed between the former and the latter. As used herein, when a layer, film, area, plate, or the like is directly disposed "on" or "on a top" of another layer, film, area, plate, or the like, the former directly contacts the latter and still another layer, film, area, plate, or the like is not disposed between the former and the latter. Further, as used herein, when a layer, film, area, plate, or the like is disposed "below" or "under" another layer, film, area, plate, or the like, the former may directly contact the latter or still another layer, film, area, plate, or the like may be disposed between the former and the latter. As used herein, when a layer, film, area, plate, or the like is directly disposed "below" or "under" another layer, film, area, plate, or the like, the former directly contacts the latter and still another layer, film, area, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is indicated.

When a certain implementation may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, areas, layers and/or periods, these elements, components, areas, layers and/or periods should not be limited by these terms. These terms are used to distinguish one element, component, area, layer or section from another element, component, area, layer or section. Thus, a first element, component, area, layer or section as described under could be termed a second element, component, area, layer or section, without departing from the spirit and scope of the present disclosure.

When an implementation may be implemented differently, functions or operations specified within a specific block may be performed in a different order from an order specified in a flowchart. For example, two consecutive blocks may actually be performed substantially simultaneously, or the blocks may be performed in a reverse order depending on related functions or operations.

The features of the various implementations of the present disclosure may be partially or entirely combined with each other, and may be technically associated with each other or operate with each other. The implementations may be implemented independently of each other and may be implemented together in an association relationship.

In interpreting a numerical value, the value is interpreted as including an error range unless there is a separate explicit description thereof.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "implementations," "examples," "aspects, etc. should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means one of natural inclusive permutations.

The terms used in the description as set forth below have been selected as being general and universal in the related technical field. However, there may be other terms than the terms depending on the development and/or change of technology, convention, preference of technicians, etc. Therefore, the terms used in the description as set forth below should not be understood as limiting technical ideas, but should be understood as examples of the terms for illustrating implementations.

Further, in a specific case, a term may be arbitrarily selected by the applicant, and in this case, the detailed meaning thereof will be described in a corresponding description period. Therefore, the terms used in the description as set forth below should be understood based on not simply the name of the terms, but the meaning of the terms and the contents throughout the Detailed Descriptions.

In description of flow of a signal, for example, when a signal is delivered from a node A to a node B, this may include a case where the signal is transferred from the node A to the node B through another node unless a phrase 'immediately transferred' or 'directly transferred' is used.

Throughout the present disclosure, "A and/or B" means A, B, or A and B, unless otherwise specified, and "C to D" means C inclusive to D inclusive unless otherwise specified.

As used herein, a first direction, a second direction, and a third direction, or an X-axis direction, a Y-axis direction, and a Z-axis direction should not be interpreted only as having a geometric relationship with each other in which the first direction, the second direction, and the third direction are perpendicular to each other or the X-axis direction, the Y-axis direction, and the Z-axis direction are perpendicular to each other, but may be interpreted as having a geometric relationship with each other in which the first direction, the second direction, and the third direction interest each other at an angle other than 90 degrees or the X-axis direction, the Y-axis direction, and the Z-axis direction are interest each other at an angle other than 90 degrees within a range in which a configuration of the present disclosure may work functionally.

When a first component or layer is described as "contacting" or "overlapping" a second component or layer, it should be understood that the first component or layer may directly contact or overlap the second component or layer, or a third component or layer may be interposed between the first and second components or layers that may indirectly contact or overlap each other unless otherwise specified.

Hereinafter, various implementations of the present disclosure will be described in detail with reference to the accompanying drawings.

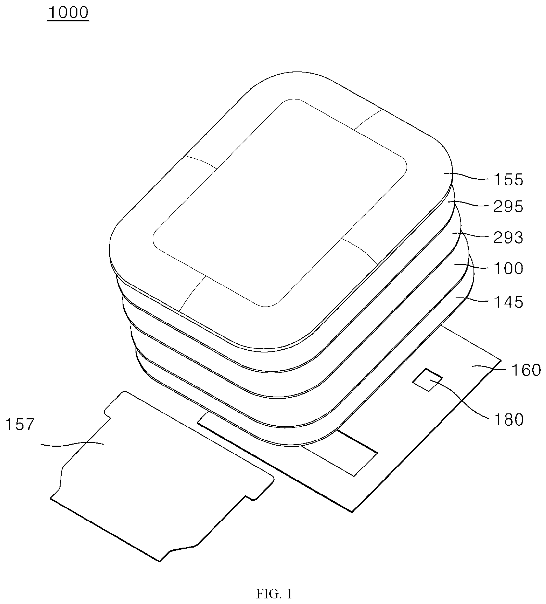

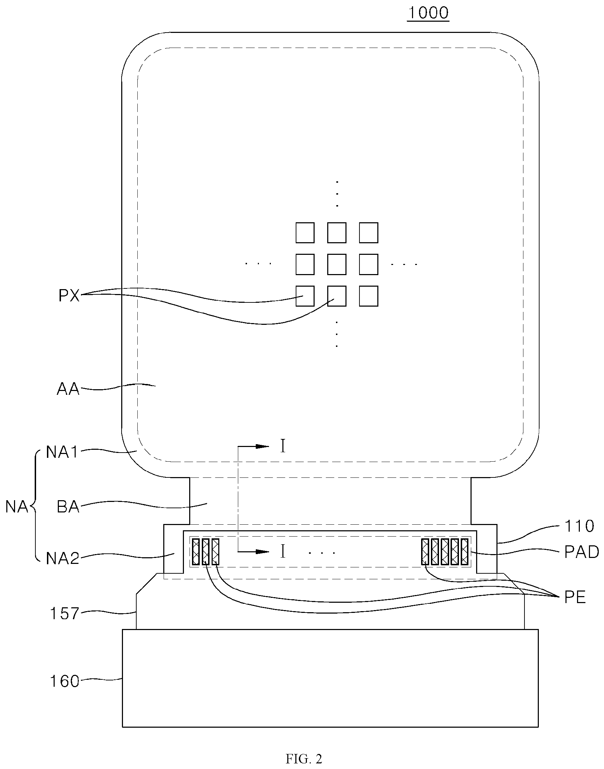

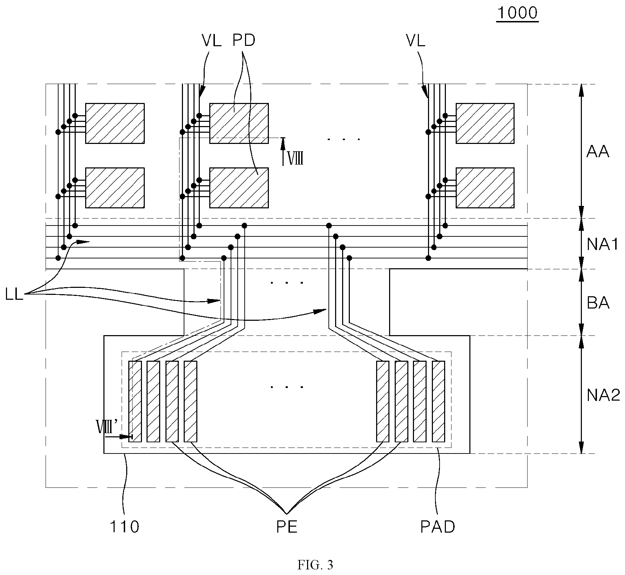

FIG. 1 is an exploded perspective view of a display device according to an implementation of the present disclosure. FIG. 2 is a plan view of a display device according to an implementation of the present disclosure. FIG. 3 is an enlarged view of a display device according to an implementation of the present disclosure.

Referring to FIGS. 1 to 3, a display device 1000 according to an implementation of the present disclosure may include a display panel 100, a polarizing layer 293, an adhesive layer 295, a cover member 155, a support substrate 145, a flexible circuit board 157, and a printed circuit board 160.

For example, the display device 1000 may include a substrate 110. The substrate 110 may be a member supporting other components of the display device 1000. The substrate 110 may be made of an insulating material. For example, the substrate 110 may be made of glass or resin. In addition, the substrate 110 may be made of a material having flexibility. For example, the substrate 110 may be made of a plastic material having flexibility, such as polyimide (PI). However, implementations of the present disclosure are not limited thereto.

The display panel 100 may implement information, a video, and/or an image to be provided to a user. For example, the display panel 100 may include a display area AA and a non-display area NA. For example, the substrate 110 may include the display area AA and the non-display area NA. The distinction between the display area AA and the non-display area NA is applied not only to the substrate 110 but also to the display device 1000.

The display area AA may be an area in which an image is displayed. The display area AA may include a plurality of pixels PX. Each of the plurality of pixels PX may be composed of a plurality of sub-pixels. A plurality of light-emitting elements may be disposed in each of the plurality of sub-pixels SP. A type of each of the plurality of light-emitting elements may vary according to a type of the display device 1000. For example, when the display device 1000 is an inorganic light-emitting display device, the light-emitting element may be a light-emitting diode (LED), a micro light-emitting diode (LED), or a mini light-emitting diode (LED). However, implementations of the present disclosure are not limited thereto.

The non-display area NA may be an area in which no image is displayed. Various lines and circuits for driving the plurality of pixels PX of the display area AA may be disposed in the non-display area NA. For example, various wires and driving circuits may be mounted in the non-display area NA, and a pad PAD to which an integrated circuit, a printed circuit, etc. are connected may be disposed in the non-display area NA. However, implementations of the present disclosure are not limited thereto.

For example, the driving circuit may be a data driving circuit and/or a gate driving circuit. However, implementations of the present disclosure are not limited thereto. Wires to which a control signal for controlling the driving circuits is supplied may be disposed. For example, the control signal may include various timing signals including a clock signal, an input data enable signal, and synchronization signals. However, implementations of the present disclosure are not limited thereto. The control signal may be received through the pad PAD. For example, link lines LL for transmitting signals may be disposed in the non-display area NA. For example, driving components such as a flexible printed circuit board 157 and a printed circuit board 160 may be connected to the pad PAD.

According to the present disclosure, the non-display area NA may include a first non-display area NA1, a bending area BA, and a second non-display area NA2. For example, the first non-display area NA1 may be an area surrounding at least a portion of the display area AA. The bending area BA is an area extending from at least one of a plurality of sides of the first non-display area NA1 and may be a bendable area. The second non-display area NA2 may be an area extending from the bending area BA, and the pad PAD may be disposed in the second non-display area. For example, the bending area BA may be in a bent state, and the remaining area of the substrate 110 except for the bending area BA may be in a flat state. In this case, as the bending area BA is bent, the second non-display area NA2 may be located on a rear surface of the display area AA. However, implementations of the present disclosure are not limited thereto.

The display area AA of the substrate 110 or the display device 1000 may be formed in various shapes according to the designs of the display device 1000. For example, the display area AA may be formed in a rectangular shape having four corners of a round shape. However, implementations of the present disclosure are not limited thereto. In another example, the display area AA may be formed in a rectangular shape in which four corners have a right angle or a circular shape. However, implementations of the present disclosure are not limited thereto.

According to the present disclosure, a width of the second non-display area NA2 in which a plurality of pad electrodes PE are disposed may be greater than a width of the bending area BA in which only a plurality of link lines LL are disposed. In addition, the width of the display area AA in which the plurality of sub-pixels are disposed may be greater than the width of the bending area BA in which only the plurality of link lines LL are disposed. Although the width of the bending area BA is illustrated as being smaller than the width of the remaining area of the substrate 110 in the drawing, a shape of the substrate 110 including the bending area BA is merely an example, and implementations of the present disclosure are not limited thereto.

Referring to FIG. 3, a plurality of pixel driving circuits PD may be disposed in the display area AA. The plurality of pixel driving circuits PD may be circuits for driving the light-emitting elements of the plurality of sub-pixels. For example, each of the plurality of pixel driving circuits PD may perform a function of a driving transistor, and a function of a storage capacitor, etc. For example, each of the plurality of pixel driving circuits PD may control an emission operation of the plurality of light-emitting elements by supplying a control signal, a power, and a driving current to the light-emitting elements of the plurality of sub-pixels. For example, the pixel driving circuit PD may include a power line and a signal line for controlling the emission on/off and/or emission time of the light-emitting element. For example, each of the plurality of pixel driving circuits PD may be a driver manufactured using a metal-oxide-silicon field effect transistor (MOSFET) manufacturing process and disposed on a semiconductor substrate. However, implementations of the present disclosure are not limited thereto. The driver may drive the plurality of sub-pixels. For example, each of the plurality of pixel driving circuits PD may include a micro driver (pDriver). However, implementations of the present disclosure are not limited thereto. The micro driver may be implemented in a form of a chip. For example, each of the plurality of pixel driving circuits PD may include a driving chip. However, implementations of the present disclosure are not limited thereto.

Referring to FIG. 1 and FIG. 2, the flexible circuit board 157 and the printed circuit board 160 may be disposed under the display panel 100. The flexible circuit board 157 and the printed circuit board 160 may be disposed at least at one edge of the display panel 100. However, implementations of the present disclosure are not limited thereto. One side of the flexible circuit board 157 may be attached to the display panel 100 and the other side thereof may be attached to the printed circuit board 160. However, implementations of the present disclosure are not limited thereto. The flexible circuit board 157 may be a flexible film. However, implementations of the present disclosure are not limited thereto.

The pad PAD including a plurality of pad electrodes PE may be disposed in the second non-display area NA2. A driving component including one or more flexible circuit boards (or flexible films) 157 and the printed circuit board 160 may be attached or bonded to the pad PAD. The plurality of pad electrodes PE of the pad PAD may be electrically connected to one or more flexible circuit boards (or flexible films) 157, and may transmit various signals (or power) from the printed circuit board 160 and the flexible circuit boards (or flexible films) 157 to the plurality of pixel driving circuits PD of the display area AA.

The flexible circuit board (or flexible film) 157 may be a film in which various components are disposed on a flexible base film. For example, a driving IC such as a gate driver IC or a data driver IC may be disposed on the flexible circuit board (or flexible film) 157. However, implementations of the present disclosure are not limited thereto. The driving IC DT may be a component that processes data for displaying an image and a driving signal. The driving IC DT may be disposed in a manner such as a Chip On Glass (COG), a Chip On Film (COF), or a Tape Carrier Package (TCP) according to a mounted manner. However, implementations of the present disclosure are not limited thereto. The flexible circuit board (or flexible film) 157 may be attached or bonded to the plurality of pad electrodes PE via a conductive adhesive layer. However, implementations of the present disclosure are not limited thereto.

The printed circuit board 160 may be electrically connected to one or more flexible circuit boards (or flexible films) 157 and may be a component that supplies a signal to the driving IC. The printed circuit board 160 may be disposed on one side of the flexible circuit board (or flexible film) 157 so as to be electrically connected to the flexible circuit board (or flexible film) 157. Various components for supplying various signals to the driving IC may be disposed on the printed circuit board 160. For example, various components such as a timing controller, a power supply unit, a memory, or a processor may be disposed on the printed circuit board 160. For example, the printed circuit board 160 may include a power management integrated circuit (PMIC). However, implementations of the present disclosure are not limited thereto.

The printed circuit board 160 may include at least one hole 180. However, implementations of the present disclosure are not limited thereto. An internal component for sensing ambient light or temperature that may be provided to the plurality of sensors may be disposed in an area corresponding to the at least one hole 180. For example, the internal component may include an ALS (Ambient light sensor), a temperature sensor, etc. However, implementations of the present disclosure are not limited thereto. For example, the hole 180 may be a transmission hole or the like. However, implementations of the present disclosure are not limited thereto.

Referring to FIG. 1, the polarizing layer 293 may be disposed on the display panel 100. The polarizing layer 293 may prevent or reduce light generated from an external light source from entering the display panel 100 and thus affecting the light-emitting element or the like.

The cover member 155 may be disposed on the polarizing layer 293. The cover member 155 may be a member for protecting the display panel 100. The adhesive layer 295 may be disposed between the polarizing layer 293 and the cover member 155. The cover member 155 may be attached to the display panel 100 via the adhesive layer 295. The adhesive layer 295 may include an OCA (Optically clear adhesive), an OCR (Optically clear resin), a PSA (Pressure sensitive adhesive), etc. However, implementations of the present disclosure are not limited thereto.

The support substrate 145 may be disposed between the display panel 100 and the printed circuit board 160. The support substrate 145 may reinforce the rigidity of the display panel 100. The support substrate 145 may be a back plate. However, implementations of the present disclosure are not limited thereto.

Referring to FIGS. 1 to 3, the plurality of link lines LL may be disposed in the non-display area NA. The plurality of link lines LL may be lines for transmitting various signals from one or more flexible circuit boards (or flexible films) 157 and the printed circuit board 160 to the display area AA. The plurality of link lines LL may extend from the plurality of pad electrodes PE of the second non-display area NA2 toward the bending area BA and the first non-display area NA1 and may be electrically connected to the plurality of driving lines VL of the display area AA. The plurality of pixel driving circuits PD may be driven upon receiving signals from one or more flexible circuit boards (or flexible films) 157 and the printed circuit boards 160 through driving lines VL of the display area AA and the link lines LL of the non-display area NA.

For example, a plurality of driving lines VL together with the plurality of link lines LL may transmit signals output from the flexible circuit board (or flexible film) 157 and the printed circuit board 160 to the plurality of pixel driving circuits PD. The plurality of driving lines VL may be disposed in the display area AA and may be electrically connected to each of the plurality of pixel driving circuits PD. The plurality of driving lines VL may extend from the display area AA toward the non-display area NA and may be electrically connected to the plurality of link lines LL.

As the bending area BA is bent, a portion of each of the plurality of link lines LL may also be bent. Thus, stress is concentrated on a portion of the bent link line LL, and accordingly, a crack may occur in the link line LL. Accordingly, the plurality of link lines LL may be made of a conductive material having excellent ductility to reduce the cracks occurring when the bending area BA is bent. For example, the plurality of link lines LL may be made of a conductive material having excellent ductility, such as gold (Au), silver (Ag), aluminum (Al), etc. However, implementations of the present disclosure are not limited thereto. In addition, the plurality of link lines LL may be made of one of various conductive materials used in the display area AA. For example, the plurality of link lines LL may be made of molybdenum (Mo), chromium (Cr), titanium (Ti), nickel (Ni), neodymium (Nd), copper (Cu), an alloy thereof, or an alloy of silver (Ag) and magnesium (Mg). However, implementations of the present disclosure are not limited thereto. The plurality of link lines LL may be configured in a multilayer structure including various conductive materials. For example, the plurality of link lines LL may be configured in a triple layer structure of a titanium (Ti) layer/aluminum (Al) layer/titanium (Ti) layer. However, implementations of the present disclosure are not limited thereto.

The plurality of link lines LL may be formed in various shapes to reduce the stress. At least a portion of each of the plurality of link lines LL disposed on the bending area BA may extend in the same direction as an extending direction of the bending area BA, or may extend in a direction different from the extending direction of the bending area BA to reduce the stress. For example, when the bending area BA extends in one direction from the first non-display area NA1 toward the second non-display area NA2, at least a portion of the link line LL disposed on the bending area BA may extend in a direction inclined with respect to the one direction. In another example, at least a portion of each of the plurality of link lines LL may be formed in each of patterns of various shapes. For example, at least a portion of each of the plurality of link lines LL disposed on the bending area BA may have a shape in which conductive patterns having at least one of a diamond shape, a rhombus shape, a trapezoidal shape, a triangular wave shape, a sawtooth wave shape, a sine wave shape, a circular shape, and an omega (Ω) shape are repeatedly arranged. However, implementations of the present disclosure are not limited thereto.

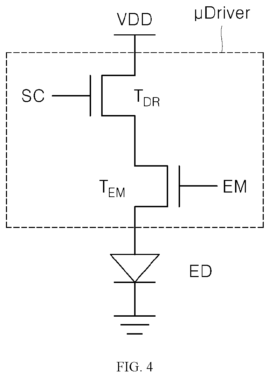

FIG. 4 is a diagram illustrating a circuit structure according to an implementation of the present disclosure.

FIG. 4 illustrates that one light-emitting element ED is connected to one micro driver µDriver. However, implementations of the present disclosure are not limited thereto. For example, eight light-emitting elements ED may be simultaneously connected to one micro driver µDriver. In another example, 16 light-emitting elements ED may simultaneously be connected to one micro driver µDriver, or 32 light-emitting elements ED or 64 light-emitting elements ED may be simultaneously connected to one micro driver µDriver or 64 light-emitting elements ED or 256 light-emitting elements ED may be simultaneously connected to one micro driver µDriver or 768 light-emitting elements ED may be simultaneously connected to one micro driver µDriver. The light-emitting element ED may be a micro light-emitting element µLED. In another example, one micro driver µDriver may control a plurality of pixels arranged in a matrix (16×16) manner in the column direction and the row direction of the substrate. Each of the plurality of pixels may include a plurality of light-emitting elements ED.

One micro driver µDriver may be implemented in a form of a chip. For example, the micro driver µDriver implemented in the form of the chip may include a driving transistor T_{DR} and a light-emission transistor T_{EM}. However, implementations of the present disclosure are not limited thereto.

For example, in the micro driver µDriver, a high potential power voltage VDD may be applied to a first electrode of the driving transistor T_{DR}, a first electrode of the light-emission transistor T_{EM} may be connected to a second electrode of the driving transistor T_{DR}, and a scan signal SC may be applied to a gate electrode of the driving transistor T_{DR} The scan signal SC applied to the gate electrode of the driving transistor T_{DR} is a direct current power, and a fixed reference voltage Vref may be applied thereto every frame. However, implementations of the present disclosure are not limited thereto.

The second electrode of the driving transistor T_{DR} may be connected to the first electrode of the light-emission transistor T_{EM}, the light-emitting element ED may be connected to a second electrode of the light-emission transistor T_{EM}, and the light-emission signal EM may be applied to a gate electrode of the light-emission transistor T_{EM}. The light- emission signal EM applied to the gate electrode of the light-emission transistor T_{EM} may be a pulse width modulation signal that varies in every frame. However, implementations of the present disclosure are not limited thereto.

The light-emitting element ED may have a first electrode connected to the second electrode of the light-emission transistor T_{EM}, and a second electrode connected to the ground. For example, the first electrode thereof may be an anode electrode, and the second electrode thereof may be a cathode electrode. However, implementations of the present disclosure are not limited thereto.

Each of the driving transistor T_{DR} and the light-emission transistor T_{EM} may be an n-type transistor or a p-type transistor.

In the micro driver µDriver, the driving transistor T_{DR} may be turned on based on the scan signal SC applied thereto from a timing controller T-CON, and the light-emission transistor T_{EM} may be turned on based on the light-emission signal EM. Accordingly, the driving current is applied to the light-emitting element ED through the driving transistor T_{DR} and the light-emission transistor T_{EM} based on the high potential power voltage VDD applied to the first electrode of the driving transistor T_{DR}, so that the light-emitting element ED may emit light.

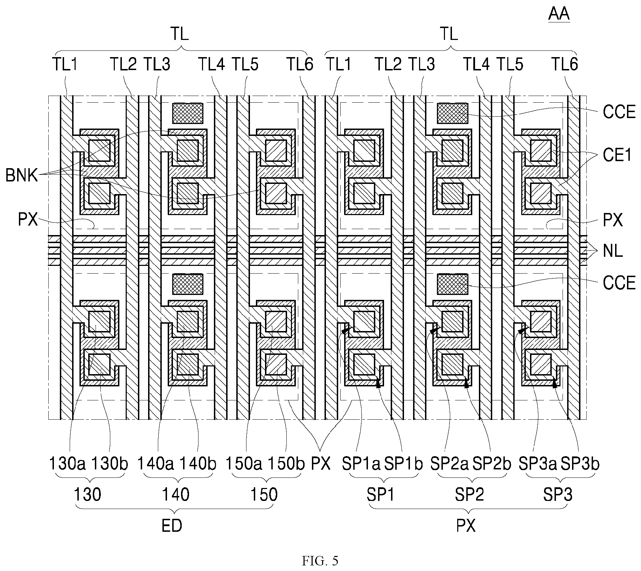

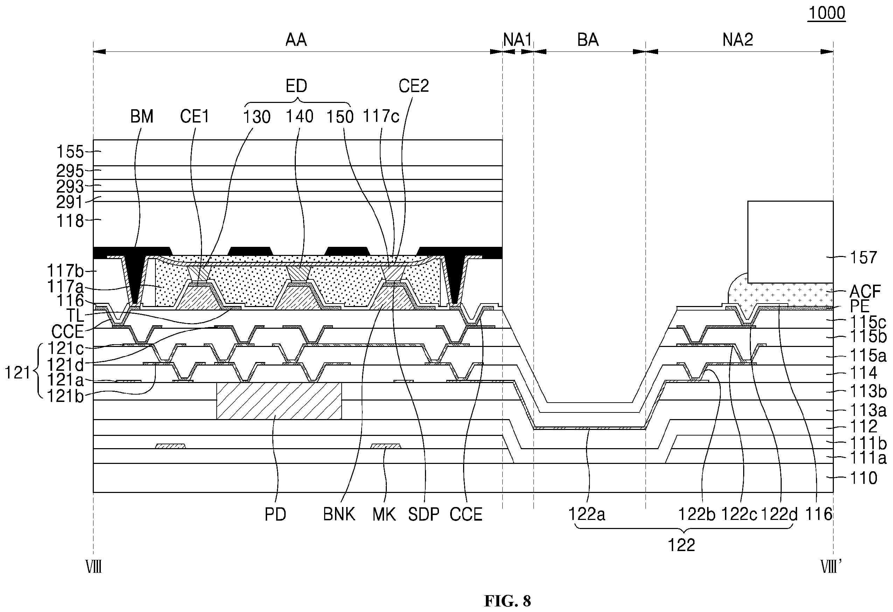

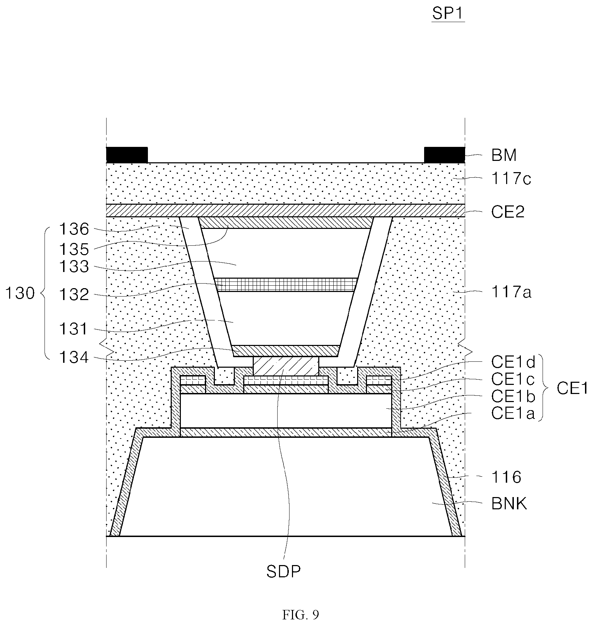

FIGS. 5 to 7 are plan views of a display device according to an implementation of the present disclosure. FIGS. 8 and 9 are cross-sectional views of a display device according to an implementation of the present disclosure.

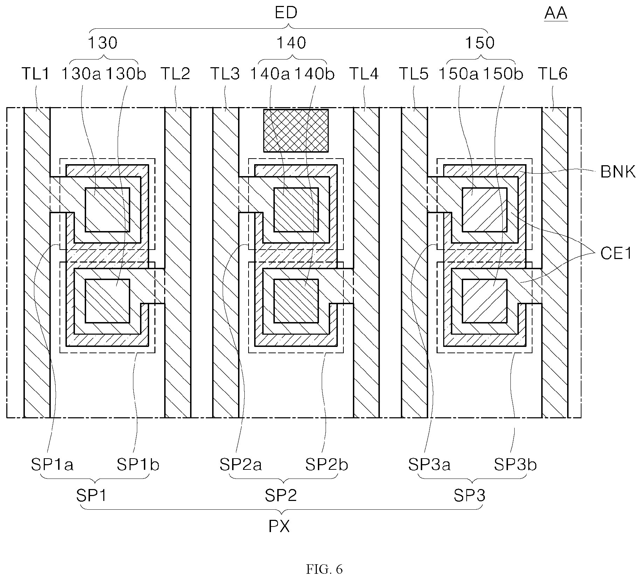

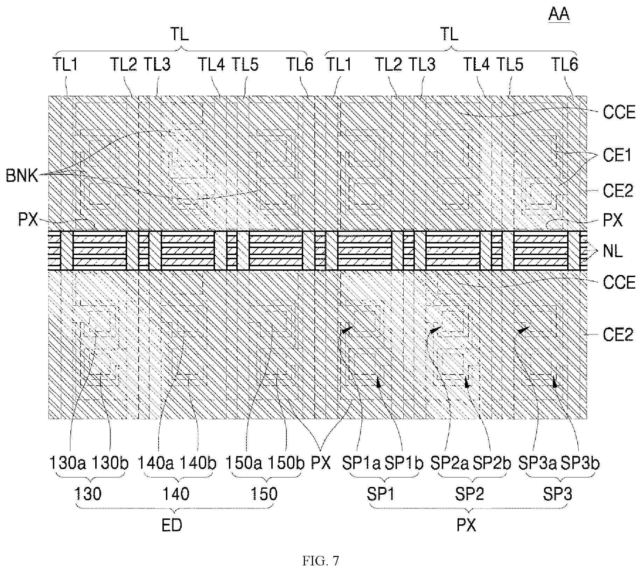

For example, FIG. 5 is an enlarged plan view of a display area including a plurality of pixels. For example, FIG. 6 is an enlarged plan view of a display area including one pixel. For example, FIG. 7 is an enlarged plan view of a display area including a plurality of pixels. For example, FIG. 8 is a cross-sectional view of the display area AA, the first non-display area NA1, the bending area BA, and the second non-display area NA2. FIG. 8 is a cross-sectional view of the display device taken along a cutting line VIII-VIII' of FIG. 3. For example, FIG. 9 is a cross-sectional view of a display area including one sub-pixel SP1. For convenience of illustration, FIG. 3 illustrates that the cutting line VIII-VIII' and the driving line VL and the link line LL do not overlap each other. However, the present disclosure is not limited thereto. The cutting line VIII-VIII' of FIG. 3 is intended for indicating that a position thereof is the same as that of each of the driving line VL and the link line LL adjacent thereto. FIGS. 5 and 6 illustrate only a plurality of signal lines TL, a plurality of communication lines NL, a plurality of first electrodes CE1, a plurality of banks BNK, and a plurality of light-emitting elements ED. However, implementations of the present disclosure are not limited thereto. FIG. 7 is an enlarged plan view in which a plurality of second electrodes CE2 are additionally disposed in FIG. 5.

Referring to FIGS. 5, 6, and 9, a plurality of pixels PX, each including a plurality of sub-pixels, may be disposed in the display area AA. Each of the plurality of sub-pixels includes a light-emitting element ED, and may independently emit light. The plurality of sub-pixels may be arranged in a plurality of rows and a plurality of columns and thus may be arranged in a matrix form. However, implementations of the present disclosure are not limited thereto.

The plurality of sub-pixels may include a first sub-pixel SP1, a second sub-pixel SP2, and a third sub-pixel SP3. For example, one of the first sub-pixel SP1, the second sub-pixel SP2, and the third sub-pixel SP3 may be a red sub-pixel, another thereof may be a green sub-pixel, and the other thereof may be a blue sub-pixel. A type of each of the plurality of sub-pixels is an example, and implementations of the present disclosure are not limited thereto.

Each of the plurality of pixels PX may include one or more first sub-pixels SP1, one or more second sub-pixels SP2, and one or more third sub-pixels SP3. For example, one pixel PX may include a pair of first sub-pixels SP1, a pair of second sub-pixels SP2, and a pair of third sub-pixels SP3. The pair of first sub-pixels SP1 may include a (1-1)-th sub-pixel SP1a and a (1-2)-th sub-pixel SP1b. The pair of second sub-pixels SP2 may include a (2-1)-th sub-pixel SP2a and a (2-2)-th sub-pixel SP2b. The pair of third sub-pixels SP3 may include a (3-1)-th sub-pixel SP3a and a (3-2)-th sub-pixel SP3b. For example, one pixel PX may include a (1-1)-th sub-pixel SP1a and a (1-2)-th sub-pixel SP1b, a (2-1)-th sub-pixel SP2a and a (2-2)-th sub-pixel SP2b, and a (3-1)-th sub-pixel SP3a and a (3-2)-th sub-pixel SP3b. However, implementations of the present disclosure are not limited thereto.

The plurality of sub-pixels constituting one pixel PX may be arranged in various manner. In one example, in one pixel PX, a pair of first sub-pixels SP1 may be arranged in the same column, a pair of second sub-pixels SP2 may be arranged in the same column, and a pair of third sub-pixels SP3 may be arranged in the same column. The first sub-pixel SP1, the second sub-pixel SP2, and the third sub-pixel SP3 may be arranged in the same row. The number and arrangement of the plurality of sub-pixels constituting one pixel PX are examples, and implementations of the present disclosure are not limited thereto.

A plurality of signal lines TL may be disposed in an area between adjacent ones of the plurality of sub-pixels. The plurality of signal lines TL may extend in the column direction while being disposed between adjacent ones of the plurality of sub-pixels. The plurality of signal lines TL may be lines for transmitting an anode voltage from the pixel driving circuit PD to the plurality of sub-pixels. For example, the plurality of signal lines TL may be electrically connected to the plurality of pixel driving circuits PD and the first electrodes CE1 of the plurality of sub-pixels. The anode voltage output from the pixel driving circuit PD may be transmitted to the first electrodes CE1 of the plurality of sub-pixels through the plurality of signal lines TL. For example, the first electrode CE1 may be an electrode electrically connected to the anode electrode 134 of the light-emitting element ED. Accordingly, the anode voltage from the signal line TL may be transmitted to the anode electrode 134 of the light-emitting element ED through the first electrode CE1.

Therefore, a structure of the display device 1000 may be simplified using the pixel driving circuit PD in which the plurality of pixel circuits are integrated with each other, instead of forming a plurality of transistors and a storage capacitor in each of the plurality of sub-pixels. In addition, as circuits respectively disposed in the plurality of sub-pixels are integrated into one pixel driving circuit PD, high-efficiency low-power operation of the display device may be achieved.

The plurality of signal lines TL may include a first signal line TL1, a second signal line TL2, a third signal line TL3, a fourth signal line TL4, a fifth signal line TL5, and a sixth signal line TL6. The first signal line TL1 and the second signal line TL2 may be electrically connected to the pair of first sub-pixels SP1, respectively. The third signal line TL3 and the fourth signal line TL4 may be electrically connected to the pair of second sub-pixels SP2, respectively. The fifth signal line TL5 and the sixth signal line TL6 may be electrically connected to the pair of third sub-pixels SP3, respectively.

The first signal line TL1 may be disposed on one side of the pair of first sub-pixels SP1, and the first signal line TL2 may be disposed on the other side of the pair of first sub-pixels SP1. The first signal line TL1 may be electrically connected to one first sub-pixel SP1 of the pair of first sub-pixels SP1, for example, the first electrode CE1 of the (1-1)-th sub-pixel SP1a. The second signal line TL2 may be electrically connected to the other first sub-pixel SP1 of the pair of first sub-pixels SP1, for example, the first electrode CE1 of the (1-2)-th sub-pixel SP1b.

The third signal line TL3 may be disposed on one side of the pair of second sub-pixels SP2, and the fourth signal line TL4 may be disposed on the other side of the pair of second sub-pixels SP2. For example, the third signal line TL3 may be disposed adjacent to the second signal line TL2. The third signal line TL3 may be electrically connected to one second sub-pixel SP2 of the pair of second sub-pixels SP2, for example, the first electrode CE1 of the (2-1)-th sub-pixel SP2a. The fourth signal line TL4 may be electrically connected to the other second sub-pixel SP2 of the pair of second sub-pixels SP2, for example, the first electrode CE1 of the (2-2)-th sub-pixel SP2b.

The fifth signal line TL5 may be disposed on one side of the pair of third sub-pixels SP3, and a sixth signal line TL6 may be disposed on the other side of the pair of third sub-pixels SP3. For example, the fifth signal line TL5 may be disposed adjacent to the fourth signal line TL4. The sixth signal line TL6 may be disposed adjacent to the first signal line TL1 connected to the pixel PX adjacent thereto. The fifth signal line TL5 may be electrically connected to one third sub-pixel SP3 of the pair of third sub-pixels SP3, for example, the first electrode CE1 of the (3-1)-th sub-pixel SP3a. The sixth signal line TL6 may be electrically connected to the other third sub-pixel SP3 of the pair of third sub-pixels SP3, for example, the first electrode CE1 of the (3-2)-th sub-pixel SP3b.

Each of the plurality of signal lines TL may be made of a conductive material. For example, each of the plurality of signal lines TL may be made of a conductive material such as titanium (Ti), aluminum (Al), copper (Cu), molybdenum (Mo), nickel (Ni), chromium (Cr), indium tin oxide (ITO), indium zinc oxide (IZO), indium gallium zinc oxide (IGZO), etc. However, implementations of the present disclosure are not limited thereto. In another example, each of the plurality of signal lines TL may have a multilayer structure made of a conductive material. For example, each of the plurality of signal lines TL may have a multilayer structure of a titanium (Ti) layer/aluminum (Al) layer/titanium (Ti) layer/indium tin oxide (ITO) layer. However, implementations of the present disclosure are not limited thereto.

A plurality of communication lines NL may be disposed in an area between adjacent ones of the plurality of pixels PX. The plurality of communication lines NL may extend in the row direction while being disposed in an area between adjacent ones of the plurality of pixels PX. The plurality of communication lines NL may be disposed in an area between adjacent ones of the plurality of second electrodes CE2 and may not overlap the plurality of second electrodes CE2. For example, the plurality of communication lines NL may be lines used for short-range communication such as near field communication (NFC). The plurality of communication lines NL may function as antennas. For example, the plurality of communication lines NL may be a plurality of connection lines, etc. However, implementations of the present disclosure are not limited thereto.

According to the present disclosure, a bank BNK may be disposed in each of the plurality of sub-pixels. Each of the plurality of banks BNK may be a structure in which each of the plurality of light-emitting elements ED is seated. The plurality of banks BNK may guide positions of the plurality of light-emitting elements ED in a transfer process of transferring the plurality of light-emitting elements ED to the substrate, respectively. In the transfer process of the plurality of light-emitting elements ED thereto, the plurality of light-emitting elements ED may be transferred onto the plurality of banks BNK, respectively. The plurality of banks BNK may be bank patterns, structures, etc. However, implementations of the present disclosure are not limited thereto.

The bank BNK of the first sub-pixel SP1, the bank BNK of the second sub-pixel SP2, and the bank BNK of the third sub-pixel SP3 may be spaced apart from each other. The bank BNK of the first sub-pixel SP1, the bank BNK of the second sub-pixel SP2, and the bank BNK of the third sub-pixel SP3 may be constructed to be isolated from each other. Accordingly, the banks BNK of the first sub-pixel SP1, the second sub-pixel SP2, and the third sub-pixel SP3 to which different types of light-emitting elements ED are transferred, respectively may be easily identified.

The bank BNK of the (1-1)-th sub-pixel SP1a and the bank BNK of the (1-2)-th sub-pixel SP1b may be connected to each other, or may be spaced apart or isolated from each other. For example, the bank BNK of the (1-1)-th sub-pixel SP1a and the bank BNK of the (1-2)-th sub-pixel SP1b in which the light-emitting elements ED of the same type are disposed, respectively may be connected to each other, or may be spaced apart or isolated from each other in consideration of a design such as a transfer process requirement. In addition, the bank BNK of the (2-1)-th sub-pixel SP2a and the bank BNK of the (2-2)-th sub-pixel SP2b may be connected to each other, or may be spaced apart or isolated from each other. The bank BNK of the (3-1)-th sub-pixel SP3a and the bank BNK of the (3-2)-th sub-pixel SP3b may be connected to each other, or may be spaced apart or isolated from each other. Accordingly, the banks BNK of the pair of first sub-pixels SP1, the banks BNK of the pair of second sub-pixels SP2, and the banks BNK of the pair of third sub-pixels SP3 may be variously formed. Implementations of the present disclosure are not limited thereto.

For example, each of the plurality of banks BNK may be made of an organic insulating material. Each of the plurality of banks BNK may be formed as a single layer or multiple layers made of an organic insulating material. For example, each of the plurality of banks BNK may be made of photoresist, polyimide (PI), or an acryl-based material. However, implementations of the present disclosure are not limited thereto.

The first electrode CE1 may be disposed in each of the plurality of sub-pixels SP. The first electrode CE1 may be disposed on the bank BNK. The first electrode CE1 may be electrically connected to one signal line TL among the plurality of signal lines TL. At least a portion of the first electrode CE1 may extend outwardly of the bank BNK and may be electrically connected to the signal line TL closest to the first electrode CE1. For example, a portion of the first electrode CE1 of the (1-1)-th sub-pixel SP1a may extend to one side area of the (1-1)-th sub-pixel SP1a so as to be electrically connected to the first signal line TL1, and a portion of the first electrode CE1 of the (1-2)-th sub-pixel SP1b may extend to the other side area of the (1-2)-th sub-pixel SP1b so as to be electrically connected to the second signal line TL2. A portion of the first electrode CE1 of the (2-1)-th sub-pixel SP2a may extend to one side area of the (2-1)-th sub-pixel SP2a so as to be electrically connected to the third signal line TL3, and a portion of the first electrode CE1 of the (2-2)-th sub-pixel SP2b may extend to the other side area of the (2-2)-th sub-pixel SP2b so as to be electrically connected to the fourth signal line TL4. A portion of the first electrode CE1 of the (3-1)-th sub-pixel SP3a may extend to one side area of the (3-1)-th sub-pixel SP3a so as to be electrically connected to the fifth signal line TL5, and a portion of the first electrode CE1 of the (3-2)-th sub-pixel SP3b may extend to the other side area of the (3-2)-th sub-pixel SP3b so as to be electrically connected to the sixth signal line TL6.

The first electrode CE1 may be electrically connected to the anode electrode 134 of the light-emitting element ED, and may transmit an anode voltage from the pixel driving circuit PD to the light-emitting element ED through the signal line TL. Different voltages may be respectively applied to the first electrodes CE1 of the plurality of sub-pixels based on a displayed image. For example, different voltages may be applied to the first electrodes CE1 of the plurality of sub-pixels SP, respectively. Accordingly, the first electrode CE1 may be a pixel electrode, and implementations of the present disclosure are not limited thereto.

The first electrode CE1 may be made of a conductive material. For example, the first electrode CE1 may be integrally formed with the plurality of signal lines TL. For example, the first electrode CE1 may be made of the same conductive material as that of each of the plurality of signal lines TL. However, implementations of the present disclosure are not limited thereto.

The light-emitting element ED may be disposed in each of the plurality of sub-pixels. The plurality of light-emitting elements ED may be one of a light-emitting diode (LED) or a micro light-emitting diode (LED). However, implementations of the present disclosure are not limited thereto. The plurality of light-emitting elements ED may be disposed on the bank BNK and the first electrode CE1. The plurality of light-emitting elements ED may be disposed on the first electrode CE1 and may be electrically connected to the first electrode CE1. Accordingly, the light-emitting element ED may receive the anode voltage from the pixel driving circuit PD through the signal line TL and the first electrode CE1 to emit light.

The plurality of light-emitting elements ED may include a first light-emitting element 130, a second light-emitting element 140, and a third light-emitting element 150. The plurality of light-emitting elements ED may include, for example, the first light-emitting element 130 for red light emission, the second light-emitting element 140 for green light emission, and the third light-emitting element 150 for blue light emission. The first light-emitting element 130 may have a size larger than a size of each of the second light-emitting element 140 and the third light-emitting element 150.

The first light-emitting element 130 may be disposed in the first sub-pixel SP1. The second light-emitting element 140 may be disposed in the second sub-pixel SP2. The third light-emitting element 150 may be disposed in the third sub-pixel SP3. For example, one of the first light-emitting element 130, the second light-emitting element 140, and the third light-emitting element 150 may be a red light-emitting element, another thereof may be a green light-emitting element, and the other thereof may be a blue light-emitting element. However, implementations of the present disclosure are not limited thereto. Accordingly, various colors of light including white may be implemented by combining red light, green light, and blue light respectively emitted from the plurality of light-emitting elements ED from each other. The type of each of the plurality of light-emitting elements ED is merely an example, and implementations of the present disclosure are not limited thereto.

The first light-emitting element 130 may include a (1-1)-th light-emitting element 130a disposed in the (1-1)-th sub-pixel SP1a and a (1-2)-th light-emitting element 130b disposed in the (1-2)-th sub-pixel SP1b. The second light-emitting element 140 may include a (2-1)-th light-emitting element 140a disposed in the (2-1)-th sub-pixel SP2a and a (2-2)-th light-emitting element 140b disposed in the (2-2)-th sub-pixel SP2b. The third light-emitting element 150 may include a (3-1)-th light-emitting element 150a disposed in the (3-1)-th sub-pixel SP3a and a (3-2)-th light-emitting element 150b disposed in the (3-2)-th sub-pixel SP3b.

Referring to FIGS. 5 and 6, and FIGS. 7 and 9 together, the second electrode CE2 may be disposed in each of the plurality of sub-pixels SP. The second electrode CE2 may be disposed on the light-emitting element ED. The second electrode CE2 may be electrically connected to the pixel driving circuit PD through a plurality of contact electrodes CCE.

For example, the second electrode CE2 may be electrically connected to the cathode electrode 135 of the light-emitting element ED to transmit the cathode voltage from the pixel driving circuit PD to the light-emitting element ED. The same cathode voltage may be applied to the second electrodes CE2 of the plurality of sub-pixels SP. For example, the same voltage may be applied to the second electrodes CE2 of the plurality of sub-pixels and the cathode electrode 135 of the light-emitting element ED. Accordingly, the second electrode CE2 may be a common electrode. However, implementations of the present disclosure are not limited thereto.

At least some of the plurality of sub-pixels may share the second electrode CE2 with each other. At least some of the second electrodes CE2 of the plurality of sub-pixels SP may be electrically connected to each other. As the same voltage is applied to the second electrodes CE2, the second electrode CE2 may be shared by the at least some sub-pixels. For example, the second electrodes CE2 of at least some pixels PX among the plurality of pixels PX disposed in the same row may be connected to each other. For example, one second electrode CE2 may be disposed in the plurality of pixels PX. One second electrode CE2 may be disposed in a combination of n sub-pixels.

For example, some of the respective second electrodes CE2 of the plurality of sub-pixels SP may be spaced apart or isolated from each other. For example, the second electrode CE2 connected to the pixels PX of an n-th row and the second electrode CE2 connected to the pixels PX of an (n+1)-th row may be spaced apart or isolated from each other. For example, adjacent ones of the plurality of second electrodes CE2 may be arranged to be spaced apart from each other while the plurality of communication lines NL extending in the row direction are disposed therebetween. Accordingly, the number of the plurality of sub-pixels may be greater than the number of the plurality of second electrodes CE2. In another example, all of the second electrodes CE2 of the plurality of sub-pixels may be connected to each other, such that only one second electrode CE2 may be disposed on the substrate 110. However, implementations of the present disclosure are not limited thereto.

Each of the plurality of second electrodes CE2 may be made of a transparent conductive material. However, implementations of the present disclosure are not limited thereto. Each of the plurality of second electrodes CE2 may be made of a transparent conductive material, and may allow light emitted from the light-emitting element ED to be directed upwardly of the second electrode CE2. For example, the second electrode CE2 may be made of a transparent conductive material such as Indium Tin Oxide (ITO), Indium Zinc Oxide (IZO), Indium Gallium Zinc Oxide (IGZO), etc. However, implementations of the present disclosure are not limited thereto.

The plurality of contact electrodes CCE may be disposed on the substrate 110. For example, the plurality of contact electrodes CCE may be disposed to be spaced apart from the plurality of banks BNK and the plurality of signal lines TL. Each of the plurality of second electrodes CE2 may overlap at least one contact electrode CCE. For example, one second electrode CE2 may overlap the plurality of contact electrodes CCE.

For example, each of the plurality of contact electrodes CCE may be electrically connected to each of the plurality of second electrodes CE2. Each of the plurality of contact electrodes CCE may be disposed between the substrate 110 and each of the plurality of second electrodes CE2 to transmit the cathode voltage from the pixel pixel driving circuit PD to each of the second electrodes CE2.

For example, when the micro LED is used as the light-emitting element ED, a plurality of micro LEDs may be formed on a wafer, and the micro LEDs may be transferred to the substrate 110 of the display device 1000 to manufacture the display device 1000. Various defects may occur in the process of transferring the plurality of light-emitting elements ED having a fine size from the wafer to the substrate 110. For example, a non-transfer defect in which the light-emitting element ED is not transferred may occur in some sub-pixels, and an incorrect position defect in which the light-emitting element ED is transferred out of the correct position due to an alignment error may occur in some further sub-pixels. In addition, the transfer process is normally performed, while the transferred light-emitting element ED itself may be defective. Therefore, the plurality of light-emitting elements ED of the same type may be transferred to one sub-pixel in consideration of the defect in the transfer process of the plurality of light-emitting elements ED. The lighting test of the plurality of light-emitting elements ED is performed, and only one light-emitting element ED that has been finally determined to be normal or non-defective may be used.

For example, both the (1-1)-th light-emitting element 130a and the (1-2)-th light-emitting element 130b may be transferred to one pixel PX at the same time, and whether they are defective may be inspected. When both the (1-1)-th light-emitting element 130a and the (1-2)-th light-emitting element 130b are determined to be normal or non-defective, only the (1-1)-th light-emitting element 130a may be used, and the (1-2)-th light-emitting element 130b may not be used. In another example, when only the (1-2)-th light-emitting element 130b among the (1-1)-th light-emitting element 130a and the (1-2)-th light-emitting element 130b is determined to be normal or non-defective, the (1-1)-th light-emitting element 130a may not be used and only the (1-2)-th light-emitting element 130b may be used. Therefore, even when the plurality of light-emitting elements ED of the same type are transferred to one pixel PX, only one light-emitting element ED may be finally used.

Accordingly, one of the pair of light-emitting elements ED may act as a main ( primary) light-emitting element ED, and the other of the pair of light-emitting elements ED may act as a redundant light-emitting element ED. The redundant light-emitting element ED may be an extra light-emitting element ED that is transferred in preparation for the defect of the main light-emitting element ED. When the main light-emitting element ED is defective, the main light-emitting element ED may be replaced with the redundant light-emitting element ED. Accordingly, both the main light-emitting element ED and the redundant light-emitting element ED are transferred to one pixel PX at the same time, thereby minimizing a decrease in display quality due to the defect of the main light-emitting element ED and the redundant light-emitting element ED.

For example, each of the (1-1)-th light-emitting element 130a, the (2-1)-th light-emitting element 140a, and the (3-1)-th light-emitting element 150a transferred to one pixel PX may be used as the main light-emitting element ED, while each of the (1-2)-th light-emitting element 130b, the (2-2)-th light-emitting element 140b, and the (3-2)-th light-emitting element 150b may be used as the redundant light-emitting element ED.

FIG. 8 is a cross-sectional view of a display device according to an implementation of the present disclosure. FIG. 9 is a cross-sectional view of a display device according to an implementation of the present disclosure. For example, FIG. 8 is a cross-sectional view of the display area AA, the first non-display area NA1, the bending area BA, and the second non-display area NA2. FIG. 8 is a cross-sectional view of the display device taken along the cutting line VIII-VIII' of FIG. 3. For example, FIG. 9 is a cross-sectional view of a display area including one sub-pixel SP1. For convenience of illustration, FIG. 3 illustrates that the cutting line VIII-VIII' and the driving line VL and the link line LL do not overlap each other. However, the present disclosure is not limited thereto. The cutting line VIII-VIII' of FIG. 3 is intended for indicating that a position thereof is the same as that of each of the driving line VL and the link line LL adjacent thereto.

Referring to FIG. 8, a first buffer layer 111a and a second buffer layer 111b may be disposed on the remaining area of the substrate 110 except for the bending area BA.

The first buffer layer 111a and the second buffer layer 111b may be disposed in the display area AA, the first non-display area NA1, and the second non-display area NA2. The first buffer layer 111a and the second buffer layer 111b may reduce invasion of moisture or impurities through the substrate 110. Each of the first buffer layer 111a and the second buffer layer 111b may be made of an inorganic insulating material. For example, each of the first buffer layer 111a and the second buffer layer 111b may be formed as a single layer or multiple layers made of silicon oxide (SiOx) or silicon nitride (SiNx). However, implementations of the present disclosure are not limited thereto.

For example, a portion of each of the first buffer layer 111a and the second buffer layer 111b in the bending area BA may be removed. An upper surface of a portion of the substrate 110 located in the bending area BA may be not covered with the first buffer layer 111a and the second buffer layer 111b so as to be exposed. Removing the portion of each of the first buffer layer 111a and the second buffer layer 111b made of the inorganic insulating material as disposed in the bending area BA may allow cracks of the first buffer layer 111a and the second buffer layer 111b that may occur during bending to be minimized.

A plurality of alignment keys MK may be disposed between the first buffer layer 111a and the second buffer layer 111b. The plurality of alignment keys MK may be configured to identify the position of the pixel driving circuit PD during the manufacturing process of the display device 1000. For example, the plurality of alignment keys MK may be configured to correctly align the positions of the pixel driving circuits PD transferred onto the adhesive layer 112. In another example, the plurality of alignment keys MK may be omitted.

The adhesive layer 112 may be disposed on the second buffer layer 111b. The adhesive layer 112 may be disposed in the display area AA, the first non-display area NA1, the bending area BA, and the second non-display area NA2. In another example, at least a portion of the adhesive layer 112 may be removed in the non-display area NA including the bending area BA. For example, the adhesive layer 112 may be made of one of an adhesive polymer, an epoxy resin, a UV curable resin, a polyimide-based resin, an acrylate-based resin, a urethane-based resin, and polydimethylsiloxane (PDMS). However, implementations of the present disclosure are not limited thereto.

The pixel driving circuit PD may be disposed on the adhesive layer 112 and in the display area AA. When the pixel driving circuit PD is implemented as a driver, the driver may be mounted on the adhesive layer 112 in a transfer process. However, implementations of the present disclosure are not limited thereto.

A first protective layer 113a and a second protective layer 113b may be disposed on the adhesive layer 112 and the pixel driving circuit PD. The first protective layer 113a and the second protective layer 113b may be disposed to surround a side surface of the pixel driving circuit PD. However, implementations of the present disclosure are not limited thereto. For example, the second protective layer 113b may be disposed to cover at least a portion of an upper surface of the pixel driving circuit PD. For example, at least one of the first protective layer 113a and the second protective layer 113b disposed on the bending area BA may be omitted. For example, the first protective layer 113a may be entirely disposed in the display area AA and the non-display area NA, and the second protective layer 113b may be partially disposed in the display area AA, the first non-display area NA1, and the second non-display area NA2. For example, a portion of the second protective layer 113b in the bending area BA may be removed. However, implementations of the present disclosure are not limited thereto.

Each of the first protective layer 113a and the second protective layer 113b may be made of an organic insulating material. However, implementations of the present disclosure are not limited thereto. For example, each of the first protective layer 113a and the second protective layer 113b may be made of a photoresist, polyimide (PI), or a photo acryl-based material. However, implementations of the present disclosure are not limited thereto. For example, each of the first protective layer 113a and the second protective layer 113b may be embodied as an overcoat layer or an insulating layer. However, implementations of the present disclosure are not limited thereto.

According to the present disclosure, a plurality of first connection lines 121 may be disposed on the second protective layer 113b and in the display area AA. The plurality of first connection lines 121 may be lines for electrically connecting the pixel driving circuit PD to other components. For example, the pixel driving circuit PD may be electrically connected to the plurality of signal lines TL and the plurality of contact electrodes CCE through the plurality of first connection lines 121. For example, the plurality of first connection lines 121 may include a (1-1)-th connection line 121a, a (1-2)-th connection line 121b, a (1-3)-th connection line 121c, and a (1-4)-th connection line 121d. However, implementations of the present disclosure are not limited thereto.

For example, a plurality of (1-1)-th connection lines 121a may be disposed on the second protective layer 113b. The plurality of (1-1)-th connection lines 121a may be electrically connected to the pixel driving circuit PD. The plurality of (1-1)-th connection lines 121a may transmit a voltage output from the pixel driving circuit PD to the first electrode CE1 or the second electrode CE2.

For example, a third protective layer 114 may be disposed on the second protective layer 113b. The protective layer 114 may be entirely disposed in the display area AA and the non-display area NA. In the bending area BA, the third protective layer 114 may cover a side surface of the second protective layer 113b and an upper surface of the first protective layer 113a. The third protective layer 114 may be made of an organic insulating material. For example, the third protective layer 114 may be made of a photoresist, polyimide (PI), or a photo acryl-based material. However, implementations of the present disclosure are not limited thereto. For example, the first protective layer 113a, the second protective layer 113b, and the third protective layer 114 may be made of the same material. Implementations of the present disclosure are not limited thereto.

A plurality of (1-2)-th connection lines 121b may be disposed on the third protective layer 114. The plurality of (1-2)-th connection lines 121b may be indirectly connected to the pixel driving circuit PD or may be directly connected thereto. For example, some of the (1-2)-th connection lines 121b may be directly connected to the pixel driving circuit PD via a contact hole of the third protective layer 114. The others of the (1-2)-th connection line 121b may be electrically connected to the (1-1)-th connection line 121a via a contact hole of the third protective layer 114. However, implementations of the present disclosure are not limited thereto. The voltage output from the pixel driving circuit PD may be transmitted to the first electrode CE1 or the second electrode CE2 through a connection line different from the plurality of (1-2)-th connection lines 121b.

A first insulating layer 115a may be disposed on the plurality of (1-2)-th connection lines 121b. The first insulating layer 115a may be entirely disposed in the display area AA and the non-display area NA. However, implementations of the present disclosure are not limited thereto. The first insulating layer 115a may be made of an organic insulating material. However, implementations of the present disclosure are not limited thereto. For example, the first insulating layer 115a may be made of a photo resist, polyimide (PI), or a photo acryl-based material. However, implementations of the present disclosure are not limited thereto.

A plurality of (1-3)-th connection lines 121c may be disposed on the first insulating layer 115a. The plurality of (1-3)-th connection lines 121c may be electrically connected to the plurality of (1-2)-th connection lines 121b, respectively. For example, the (1-3)-th connection line 121c may be electrically connected to the (1-2)-th connection line 121b via a contact hole of the first insulating layer 115a.

A second insulating layer 115b may be disposed on the plurality of (1-3)-th connection lines 121c. The second insulating layer 115b may be disposed in the remaining area except for the bending area BA. However, implementations of the present disclosure are not limited thereto. The second insulating layer 115b may be disposed in the display area AA, the first non-display area NA1, and the second non-display area NA2. However, implementations of the present disclosure are not limited thereto. For example, a portion of the second insulating layer 115b disposed in the bending area BA may be removed. The second insulating layer 115b may be made of an organic insulating material. However, implementations of the present disclosure are not limited thereto. For example, the second insulating layer 115b may be made of a photo resist, polyimide (PI), or a photo acryl-based material. However, implementations of the present disclosure are not limited thereto.

A plurality of (1-4)-th connection lines 121d may be disposed on the second insulating layer 115b. The plurality of (1-4)-th connection lines 121d may be electrically connected to the plurality of (1-3)-th connection lines 121c, respectively. For example, the (1-4)-th connection line 121d may be electrically connected to the (1-3)-th connection line 121c via a contact hole of the second insulating layer 115b.

According to the present disclosure, a plurality of second connection lines 122 may be disposed on the second protective layer 113b and in the non-display area NA. The plurality of second connection lines 122 may be lines for transmitting signals transmitted from the flexible circuit board 157 and the printed circuit board 160 (see FIG. 1) to the pad PAD to the pixel driving circuit PD of the display area AA. For example, the plurality of second connection lines 122 may be electrically connected to the plurality of pad electrodes PE respectively to receive signals from the flexible circuit board (or flexible film) 157 and the printed circuit board.

For example, the plurality of second connection lines 122 may extend from the pad PAD toward the display area AA to transmit signals to the lines of the display area AA. In this case, the plurality of second connection lines 122 may function as link lines LL. The plurality of second connection lines 122 may include a (2-1)-th connection line 122a, a (2-2)-th connection line 122b, a (2-3)-th connection line 122c, and a (2-4)-th connection line 122d.

A plurality of (2-1)-th connection lines 122a may be disposed on the second protective layer 113b. The plurality of (2-1)-th connection lines 122a may extend from the second non-display area NA2 to the bending area BA and the first non-display area NA1. The plurality of (2-1)-th connection lines 122a may transmit signals transmitted from the flexible circuit board (or flexible film) 157 and the printed circuit board to the pad PAD to the pixel driving circuit PD of the display area AA. For example, the (2-1)-th connection line 122a may be electrically connected to the pixel driving circuit PD through the first connection line 121 of the display area AA. The (2-1)-th connection line 122a may be electrically connected to the second electrode CE2 through the first connection line 121 and the contact electrode CCE of the display area AA.

A plurality of (2-2)-th connection lines 122b may be disposed on the third protective layer 114. The plurality of (2-2)-th connection lines 122b may be disposed in the second non-display area NA2. The (2-2)-th connection line 122b may be electrically connected to the (2-1)-th connection line 122a via a contact hole of the third protective layer 114. Accordingly, signals from the flexible circuit board (or flexible film) 157 and the printed circuit board may be transmitted to the (2-2)-th connection line 122b through the (2-1)-th connection line 122a.

The (2-3)-th connection line 122c may be disposed on the first insulating layer 115a. The (2-3)-th connection line 122c may be disposed in the second non-display area NA2. The (2-3)-th connection line 122c may be electrically connected to the (2-2)-th connection line 122b via a contact hole of the first insulating layer 115a. Accordingly, signals from the flexible circuit board (or flexible film) 157 and the printed circuit board may be transmitted to the (2-1)-th connection line 122a through the (2-3)-th connection line 122c and the (2-2)-th connection line 122b.

The (2-4)-th connection line 122d may be disposed on the second insulating layer 115b. The (2-4)-th connection line 122d may be disposed in the second non-display area NA2. The (2-4)-th connection line 122d may be electrically connected to the (2-3)-th connection line 122c via a contact hole of the second organic insulating layer 115c. Accordingly, signals from the flexible film FF and the printed circuit board may be transmitted to the (2-1)-th connection line 122a through the (2-4)-th connection line 122d, the (2-3)-th connection line 122c, and the (2-2)-th connection line 122b.

Each of the plurality of first connection lines 121 and the plurality of second connection lines 122 may be made of a conductive material having excellent ductility or various conductive materials used in the display area AA. For example, the second connection line 122, a portion of which is disposed in the bending area BA, may be made of a conductive material having excellent ductility, such as gold (Au), silver (Ag), or aluminum (Al). However, implementations of the present disclosure are not limited thereto. In another example, each of the plurality of first connection lines 121 and the plurality of second connection lines 122 may be made of molybdenum (Mo), chromium (Cr), titanium (Ti), nickel (Ni), neodymium (Nd), copper (Cu), an alloy of silver (Ag) and magnesium (Mg), or an alloy thereof. However, implementations of the present disclosure are not limited thereto.

A third insulating layer 115c may be disposed on the plurality of first connection lines 121 and the plurality of second connection lines 122. The third insulating layer 115c may be disposed in the remaining area except for the bending area BA. However, implementations of the present disclosure are not limited thereto. The third insulating layer 115c may be disposed in the display area AA, the first non-display area NA1, and the second non-display area NA2. A portion of the third insulating layer 115c in the bending area BA may be removed. The third insulating layer 115c may be made of an organic insulating material. However, implementations of the present disclosure are not limited thereto. For example, the third insulating layer 115c may be made of a photo resist, polyimide (PI), or a photo acryl-based material. However, implementations of the present disclosure are not limited thereto.

In the display area AA, a plurality of banks BNK may be disposed on the third insulating layer 115c. The plurality of banks BNK may be disposed to overlap the plurality of sub-pixels, respectively. One or more light-emitting elements ED of the same type may be disposed on each of the plurality of banks BNK.

In the display area AA, the plurality of signal lines TL may be disposed on the third insulating layer 115c. The plurality of signal lines TL may be disposed in an area between adjacent ones of the plurality of banks BNK. For example, the plurality of signal lines TL may be disposed adjacent to one of the plurality of banks BNK.

The plurality of contact electrodes CCE may be disposed on the third insulating layer 115c in the display area AA. The plurality of contact electrodes CCE may supply the cathode voltage from the pixel driving circuit PD to the second electrode CE2.

The first electrode CE1 may be disposed on the bank BNK. For example, the first electrode CE1 may be disposed to extend from the adjacent signal line TL toward the upper portion of the bank BNK. The first electrode CE1 may be disposed on an upper surface of the bank BNK and a side surface of the bank BNK. For example, the first electrode CE1 may be disposed to extend from the signal line TL on the upper surface of the third insulating layer 115c to the side surface of the bank BNK and the upper surface of the bank BNK.

Referring to FIG. 9, the first electrode CE1 may be made of a plurality of conductive layers. For example, the first electrode CE1 may include a first conductive layer CE1a, a second conductive layer CE1b, a third conductive layer CE1c, and a fourth conductive layer CE1d. However, implementations of the present disclosure are not limited thereto.

The first conductive layer CE1a may be disposed on the bank BNK. The second conductive layer CE1b may be disposed on the first conductive layer CE1a. The third conductive layer CE1c may be disposed on the second conductive layer CE1b, and the fourth conductive layer CE1d may be disposed on the third conductive layer CE1c. For example, each of the first conductive layer CE1a, the second conductive layer CE1b, the third conductive layer CE1c, and the fourth conductive layer CE1d may be made of titanium (Ti), molybdenum (Mo), aluminum (Al), or titanium (Ti) and indium tin oxides (ITO). However, implementations of the present disclosure are not limited thereto.

According to the present disclosure, some conductive layers having good reflection efficiency among the plurality of conductive layers constituting the first electrode CE1 may act as an alignment key for aligning the light-emitting element ED and/or a reflective plate. For example, the second conductive layer CE1b of the plurality of conductive layers of the first electrode CE1 may include a reflective material. For example, the second conductive layer CE1b may include aluminum (Al). However, implementations of the present disclosure are not limited thereto. Accordingly, the second conductive layer CE1b may act as the reflective plate. In addition, due to the high reflection efficiency of the second conductive layer CE1b, the second conductive layer CE1b may be easily identified in the manufacturing process, and thus the position of the light-emitting element ED or the transfer position may be aligned with the second conductive layer CE1b.

For example, in order that the second conductive layer CE1b acts as the reflective plate, a portion of each of the third conductive layer CE1c and the fourth conductive layer CE1d covering the second conductive layer CE1b may be removed or etched. For example, an upper surface of the second conductive layer CE1b may be exposed by removing or etching the portion of each of the third conductive layer CE1c and the fourth conductive layer CE1d disposed on the bank BNK. For example, a central portion and an edge portion (or a rim portion) of each of the third conductive layer CE1c and the fourth conductive layer CE1d, on which a solder pattern SDP is disposed, may be left, and the remaining portion other than the central portion and the edge portion thereof may be removed. For example, the edge portion (or the rim portion) of each of the third conductive layer CE1c made of titanium (Ti) and the fourth conductive layer CE1d made of indium tin oxide (ITO) may not be etched. This may prevent the other conductive layers of the first electrode CE1 from being corroded by a tetraMethylammoniumhydroxide (TMAH) solution used in a mask process of the first electrode CE1.

As described above, the first light-emitting element 130 may be adhered to the first electrode CE 1 by the solder pattern SDP.

According to the present disclosure, each of the first conductive layer CE1a and the third conductive layer CE1c may include titanium (Ti) or molybdenum (Mo). The second conductive layer CE1b may include aluminum (Al). The fourth conductive layer CE1d may include a transparent conductive oxide layer such as indium tin oxide (ITO) or indium zinc oxide (IZO), which has good adhesion to the solder pattern SDP and has corrosion resistance and acid resistance. However, implementations of the present disclosure are not limited thereto.

The first conductive layer CE1a, the second conductive layer CE1b, the third conductive layer CE1c, and the fourth conductive layer CE1d may be sequentially deposited and then patterned by performing a photolithography process and an etching process thereon. However, implementations of the present disclosure are not limited thereto.

According to the present disclosure, each of the signal line TL, the contact electrode CCE, and the pad electrode PE which are disposed at the same layer as a layer of the first electrode CE1, may be composed of multiple layers of a conductive material. However, implementations of the present disclosure are not limited thereto. For example, each of the signal line TL, the contact electrode CCE, and the pad electrode PE may be composed of a multi-layers structure of indium tin oxide (Indium Tin Oxide, ITO) layer/titanium (Ti) layer/aluminum (Al) layer/titanium (Ti) layer. However, implementations of the present disclosure are not limited thereto.

Each of the plurality of light-emitting elements 130, 140, and 150 may have a groove defined in a center of a bottom portion, and may be bonded to the first electrode CE1 by melting the solder pattern SDP that fills the groove and protrudes downwardly beyond a bottom surface of each of the plurality of light-emitting elements 130, 140, and 150.

According to the present disclosure, the solder pattern SDP may be disposed on the first electrode CE1 and in each of the plurality of sub-pixels. The solder pattern SDP may bond the light-emitting element ED to the first electrode CE1 to electrically connect the light-emitting element ED to the first electrode CE1. For example, the first electrode CE1 and the anode electrode 134 of the light-emitting element ED may be electrically connected to each other by eutectic bonding using the solder pattern SDP. However, implementations of the present disclosure are not limited thereto. For example, when the solder pattern SDP is made of indium (In) and the anode electrode 134 of the light-emitting element ED is made of gold (Au), heat and pressure may be applied thereto in the transfer process of the light-emitting element ED to bond the solder pattern SDP and the anode electrode 134 to each other. By the eutectic bonding, the light-emitting element ED may be bonded to the solder pattern SDP and the first electrode CE1 without a separate adhesive. For example, the solder pattern SDP may be made of indium (In), tin (Sn), or an alloy thereof. However, implementations of the present disclosure are not limited thereto. For example, the solder pattern SDP may be embodied as a bonding pad etc. However, implementations of the present disclosure are not limited thereto.

According to the present disclosure, a passivation layer 116 may be disposed on the plurality of signal lines TL, the plurality of first electrodes CE1, the plurality of contact electrodes CCE, and the third insulating layer 115c. For example, the passivation layer 116 may be disposed in the display area AA, the first non-display area NA1, and the second non-display area NA2. A portion of the passivation layer 116 disposed in the bending area BA may be removed. A portion of the passivation layer 116 covering the plurality of pad electrodes PE in the second non-display area NA2 may be removed. Since the passivation layer 116 is disposed to cover the remaining area except for the bending area BA, an area of the plurality of pad electrodes PE, and an area of the solder pattern SDP, penetration of moisture or impurities flowing into the light-emitting element ED may be reduced. For example, the passivation layer 116 may be formed as a single layer or multiple layers made of silicon oxide (SiOx) or silicon nitride (SiNx). However, implementations of the present disclosure are not limited thereto. For example, the passivation layer 116 may be embodied as a protective layer, an insulating layer, etc. However, implementations of the present disclosure are not limited thereto. For example, the passivation layer 116 may have a hole defined therein exposing the solder pattern SDP.

In each of the plurality of sub-pixels, the light-emitting element ED may be disposed on the solder pattern SDP. The first light-emitting element 130 may be disposed in the first sub-pixel SP1. The second light-emitting element 140 may be disposed in the second sub-pixel SP2. The third light-emitting element 150 may be disposed in the third sub-pixel SP3. Each of the plurality of light-emitting elements 130, 140, and 150 may be embodied as a micro light-emitting element.

The light-emitting element ED may be formed on a silicon wafer using an Metal Organic Chemical Vapor Deposition (MOCVD) method, a Chemical Vapor Deposition (CVD) method, a Plasma-Enhanced Chemical Vapor Deposition (PECVD) method, a Molecular Beam Epitaxy (MBE) method, a Hydride Vapor Phase Epitaxy (HVPE) method, or sputtering method. However, implementations of the present disclosure are not limited thereto.

Referring to FIG. 9, the first light-emitting element 130 may include an anode electrode 134, a first semiconductor layer 131, an active layer 132, a second semiconductor layer 133, a cathode electrode 135, and an encapsulation film 136. However, implementations of the present disclosure are not limited thereto. For example, the encapsulation film 136 may not be included in the first light-emitting element 130.

The anode electrode 134 may be disposed on the solder pattern SDP. The first semiconductor layer 131 may be disposed on the anode electrode 134. The active layer 132 may be disposed on the first semiconductor layer 131. The second semiconductor layer 133 may be disposed on the active layer 132.

For example, one of the first semiconductor layer 131 and the second semiconductor layer 133 may be made of a compound semiconductor such as a group III - V , a group II -VI, or the like, and may be doped with impurities (or dopants). For example, one of the first semiconductor layer 131 and the second semiconductor layer 133 may be a semiconductor layer doped with n-type impurities, and the other thereof may be a semiconductor layer doped with p-type impurities. However, implementations of the present disclosure are not limited thereto. For example, at least one of the first semiconductor layer 131 and the second semiconductor layer 133 may be a layer in which n-type or p-type impurities are doped in a material such as gallium nitride (GaN), gallium phosphide (GaP), gallium arsenide (GaAsP), aluminum gallium indium phosphide (AlGalnP), indium aluminum phosphide (InAlP), aluminum gallium nitride (AlGaN), aluminum indium gallium nitride (AlInN), aluminum gallium arsenide (AlGaAs), or gallium arsenide (GaAs). However, implementations of the present disclosure are not limited thereto. For example, the n-type impurity may include silicon (Si), germanium (Ge), selenium (Se), carbon (C), tellurium (Te), tin (Sn), etc. However, implementations of the present disclosure are not limited thereto. For example, the p-type impurity may include magnesium (Mg), zinc (Zn), calcium (Ca), strontium (Sr), barium (Ba), beryllium (Be), etc. However, implementations of the present disclosure are not limited thereto.

For example, each of the first semiconductor layer 131 and the second semiconductor layer 133 may be made of a nitride semiconductor including n-type impurities and a nitride semiconductor including p-type impurities. However, implementations of the present disclosure are not limited thereto. For example, the first semiconductor layer 131 may be made of a nitride semiconductor including p-type impurities, and the second semiconductor layer 133 may be made of a nitride semiconductor including n-type impurities. However, implementations of the present disclosure are not limited thereto.

The active layer 132 may be disposed between the first semiconductor layer 131 and the second semiconductor layer 133. The active layer 132 may receive holes and electrons from the first semiconductor layer 131 and the second semiconductor layer 133 to emit light. For example, the active layer 132 may be composed of one of a single well structure, a multiple well structure, a single quantum well structure, a multi-quantum well (MQW) structure, a quantum dot structure, and a quantum wire structure. However, implementations of the present disclosure are not limited thereto. For example, the active layer 132 may be made of indium gallium nitride (InGaN) or gallium nitride (GaN). However, implementations of the present disclosure are not limited thereto.

In another example, the active layer 132 may include a MQW (Multi Quantum Well) structure having a well layer and a barrier layer having a higher band gap than that of the well layer. For example, the active layer 132 may include InGaN as a material of the well layer and AlGaN as a material of the barrier layer. However, implementations of the present disclosure are not limited thereto.

The anode electrode 134 may be disposed between the first semiconductor layer 131 and the solder pattern SDP. For example, the anode electrode 134 may electrically connect the first semiconductor layer 131 and the first electrode CE1 to each other. The anode voltage output from the pixel driving circuit PD may be applied to the first semiconductor layer 131 through the signal line TL, the first electrode CE1, and the anode electrode 134. For example, the anode electrode 134 may be made of a conductive material capable of eutectic bonding with the solder pattern SDP. However, implementations of the present disclosure are not limited thereto. For example, the anode electrode 134 may be made of gold (Au), tin (Sn), tungsten (W), silicon (Si), silver (Ag), titanium (Ti), iridium (Ir), chromium (Cr), indium (In), zinc (Zn), lead (Pb), nickel (Ni), platinum (Pt), copper (Cu), or an alloy thereof. However, implementations of the present disclosure are not limited thereto.

The cathode electrode 135 may be disposed on the second semiconductor layer 133. For example, the cathode electrode 135 may electrically connect the second semiconductor layer 133 and the second electrode CE2 to each other. The cathode voltage output from the pixel driving circuit PD may be applied to the second semiconductor layer 133 through the contact electrode CCE, the second electrode CE2, and the cathode electrode 135. The cathode electrode 135 may be made of a transparent conductive material so that light emitted from the light-emitting element ED may be directed upwardly of the light-emitting element ED. However, implementations of the present disclosure are not limited thereto. For example, the cathode electrode 135 may be made of a material such as Indium Tin Oxide (ITO), Indium Zinc Oxide (IZO), or Indium Gallium Zinc Oxide (IGZO). However, implementations of the present disclosure are not limited thereto.

The encapsulation film 136 may be disposed on at least a portion of each of the first semiconductor layer 131, the active layer 132, the second semiconductor layer 133, the anode electrode 134, and the cathode electrode 135. For example, the encapsulation film 136 may surround at least a portion of each of the first semiconductor layer 131, the active layer 132, the second semiconductor layer 133, the anode electrode 134, and the cathode electrode 135.

For example, the encapsulation film 136 may protect the first semiconductor layer 131, the active layer 132, and the second semiconductor layer 133. For example, the encapsulation film 136 may be disposed on a side surface of the first semiconductor layer 131, a side surface of the active layer 132, and a side surface of the second semiconductor layer 133.

For example, the encapsulation film 136 may be disposed on at least a portion of each of the anode electrode 134 and the cathode electrode 135, for example, an edge portion (or one side surface) of the anode electrode 134 and an edge portion (or one side surface) of the cathode electrode 135. At least a portion of the anode electrode 134 may not be covered with the encapsulation film 136 such that the anode electrode 134 and the solder pattern SDP are connected to each other. For example, at least a portion of the cathode electrode 135 may not be covered with the encapsulation film 136 such that the cathode electrode 135 and the second electrode CE2 are connected to each other. For example, the encapsulation film 136 may be made of an insulating material such as silicon nitride (SiNx) or silicon oxide (SiOx). However, implementations of the present disclosure are not limited thereto.

In another example, the encapsulation film 136 may have a structure in which a reflective material is dispersed in a resin layer. However, implementations of the present disclosure are not limited thereto. For example, the encapsulation film 136 may be embodied as a reflector having various structures. However, implementations of the present disclosure are not limited thereto. Light emitted from the active layer 132 may be reflected upwardly from the encapsulation film 136, thereby improving light extraction efficiency. For example, the encapsulation film 136 may be a reflective layer. However, implementations of the present disclosure are not limited thereto.

According to the present disclosure, an example in which the light-emitting element ED has a vertical structure has been described. However, implementations of the present disclosure are not limited thereto. For example, the light-emitting element ED may have a lateral structure or a flip chip structure.

Although the first light-emitting element 130 has been described with reference to FIG. 9, each of the second light-emitting element 140 and the third light-emitting element 150 may have substantially the same structure as that of the first light-emitting element 130. For example, the first semiconductor layer, the active layer, the second semiconductor layer, the anode electrode, the cathode electrode, and the encapsulation film of each of the second light-emitting element 140 and the third light-emitting element 150 may be substantially the same as the first semiconductor layer 131, the active layer 132, the second semiconductor layer 133, the anode electrode 134, the cathode electrode 135, and the encapsulation film 136 of the first light-emitting element 130, respectively.

The optical insulating layer 117 may include a first optical layer 117a, a second optical layer 117b, and a third optical layer 117c.

According to the present disclosure, the first optical layer 117a surrounding the plurality of light-emitting elements ED may be disposed in the display area AA. For example, the first optical layer 117a may be disposed to cover the plurality of light-emitting elements ED and the bank BNK in the areas of the plurality of sub-pixels. For example, the first optical layer 117a may cover the bank BNK, a portion of the passivation layer 116, and an area between adjacent ones of the plurality of light-emitting elements ED. The first optical layer 117a may be disposed in or cover an area between adjacent ones of the plurality of light-emitting elements ED included and an area between adjacent ones of the plurality of banks BNK in one pixel PX. For example, the first optical layer 117a may extend in the first direction X and the first optical layers 117a may be spaced apart from each other in the second direction Y. For example, the first optical layer 117a may be disposed between the passivation layer 116 and the second electrode CE2 so as to surround the side of each of the light-emitting element ED and the bank BNK. However, implementations of the present disclosure are not limited thereto. For example, the first optical layer 117a may act as a diffusion layer, a sidewall diffusion layer, etc. However, implementations of the present disclosure are not limited thereto.

The first optical layer 117a may include an organic insulating material in which fine particles are dispersed. However, implementations of the present disclosure are not limited thereto. For example, the first optical layer 117a may be made of siloxane in which fine metal particles such as titanium dioxide (TiO2) particles are dispersed. However, implementations of the present disclosure are not limited thereto. Light from the plurality of light-emitting elements ED may be scattered by the fine particles dispersed in the first optical layer 117a and then emitted out of the display device 1000. Accordingly, the first optical layer 117a may improve extraction efficiency of light emitted from the plurality of light-emitting elements ED.

For example, the first optical layer 117a may be disposed in each of the plurality of pixels PX, or may be commonly disposed in some pixels PX arranged in the same row. However, implementations of the present disclosure are not limited thereto. For example, the first optical layer 117a may be disposed in each of the plurality of pixels PX, or the plurality of pixels PX may share one first optical layer 117a with each other. In another example, each of the plurality of sub-pixels SP may separately include the first optical layer 117a. However, implementations of the present disclosure are not limited thereto.

According to the present disclosure, the second optical layer 117b may be disposed on the passivation layer 116 and in the display area AA. For example, the second optical layer 117b may be disposed to surround the first optical layer 117a. For example, the second optical layer 117b may be in contact with a side surface of the first optical layer 117a. For example, the second optical layer 117b may be disposed in an area between adjacent ones of the plurality of pixels PX. However, implementations of the present disclosure are not limited thereto. For example, the second optical layer 117b may act as a diffusion layer, a diffusion layer window, a window diffusion layer, etc. However, implementations of the present disclosure are not limited thereto.

The second optical layer 117b may be made of an organic insulating material. However, implementations of the present disclosure are not limited thereto. The second optical layer 117b may be made of the same material as that of the first optical layer 117a. However, implementations of the present disclosure are not limited thereto. For example, the first optical layer 117a may include fine particles, and the second optical layer 117b may not include fine particles. For example, the second optical layer 117b may be made of siloxane. However, implementations of the present disclosure are not limited thereto.

For example, a thickness of the first optical layer 117a may be smaller than a thickness of the second optical layer 117b. However, implementations of the present disclosure are not limited thereto. Accordingly, in a cross-sectional view of the device, an area in which the first optical layer 117a is disposed may include a concave portion recessed downwardly beyond an upper surface of the second optical layer 117b.

According to the present disclosure, the second electrode CE2 may be disposed on the first optical layer 117a and the second optical layer 117b. For example, the second electrode CE2 may be electrically connected to the plurality of contact electrodes CCE via a contact hole of the second optical layer 117 b. For example, the second electrode CE2 may be disposed on the plurality of light-emitting elements ED. For example, the second electrode CE2 may include a transparent conductive oxide such as indium tin oxide (ITO) or indium zinc oxide (IZO). However, implementations of the present disclosure are not limited thereto. For example, the second electrode CE2 may be disposed to be in contact with the cathode electrode 135. For example, the second electrode CE2 may overlap the first optical layer 117a. For example, the second electrode CE2 may cover a flat upper surface of an outer portion of the first optical layer 117a.

The second electrode CE2 may continuously extend in the first direction of the substrate 110. Accordingly, the plurality of pixels PX arranged in the first direction of the substrate 110 may be commonly connected to the second electrode CE2. For example, the second electrode CE2 may be commonly connected to the plurality of pixels PX.

According to the present disclosure, the second electrode CE2 may continuously extend across the first optical layer 117a, the second optical layer 117b, and the plurality of light-emitting elements ED. An area in which the first optical layer 117a is disposed may include the concave portion recessed downwardly beyond the upper surface of the second optical layer 117b. Accordingly, since a first portion of the second electrode CE2 disposed on the first optical layer 117a is disposed along and on the concave portion, a vertical level of the first portion may be lower than a vertical level of a second portion of the second electrode CE2 disposed on the second optical layer 117b.

The third optical layer 117c may be disposed on the second electrode CE2. The third optical layer 117c may be disposed to overlap the plurality of light-emitting elements ED and the first optical layer 117a. Since the third optical layer 117c is disposed on the second electrode CE2 and the plurality of light-emitting elements ED, a mura that may occur in some of the plurality of light-emitting elements ED may be suppressed. For example, when the plurality of light-emitting elements ED are transferred onto the substrate 110 of the display device 1000, an area in which spacings between adjacent ones of the plurality of light-emitting elements ED are not uniform may occur due to process variations or etc. When the spacings between adjacent ones of the plurality of light-emitting elements ED are non-uniform, respective light emission areas of the plurality of light-emitting elements ED may be non-uniformly arranged, and thus, the mura may be visually recognized by the user. Accordingly, since the third optical layer 117c configured to uniformly diffuse light is formed on top of the plurality of light-emitting elements ED, a phenomenon that the light emitted from some light-emitting elements ED is visible as the mura to the user may be suppressed. Accordingly, the light emitted from the plurality of light-emitting elements ED may be uniformly diffused by the third optical layer 117c and then be extracted out of the display device 1000, such that the luminance uniformity of the display device 1000 may be improved.

The third optical layer 117c may be made of an organic insulating material in which fine particles are dispersed. However, an implementation of the present disclosure is not limited thereto. For example, the third optical layer 117c may be made of siloxane in which fine metal particles such as titanium dioxide (TiO2) particles are dispersed. However, implementations of the present disclosure are not limited thereto. For example, the third optical layer 117c may be made of the same material as that of the first optical layer 117a. However, implementations of the present disclosure are not limited thereto. For example, the third optical layer 117c may act as a diffusion layer, an upper surface diffusion layer, etc. However, implementations of the present disclosure are not limited thereto.

According to the present disclosure, light from the plurality of light-emitting elements ED may be scattered by the fine particles dispersed in the third optical layer 117c and be emitted out of the display device 1000. The third optical layer 117c may evenly mix light beams respectively emitted from the plurality of light-emitting elements ED with each other to further improve luminance uniformity of the display device 1000. In addition, light extraction efficiency of the display device 1000 may be improved by the light being scattered from the plurality of fine particles, and accordingly, the display device 1000 may operate at a low power level.

A black matrix BM may be disposed on the second electrode CE2, the first optical layer 117a, the second optical layer 117b, and the third optical layer 117c and in the display area AA. For example, the black matrix BM may fill a contact hole of the second optical layer 117b. Since the black matrix BM is constructed to cover the display area AA, the black matrix may reduce color mixing between light beams from the plurality of sub-pixels and may prevent external light reflection. For example, since the black matrix BM is also disposed in the contact hole via which the second electrode CE2 and the contact electrode CCE are connected to each other, light leakage between adjacent ones of the plurality of sub-pixels may be prevented.

For example, the black matrix BM may be made of an opaque material. However, implementations of the present disclosure are not limited thereto. For example, the black matrix BM may be made of an organic insulating material to which a black pigment or a black dye is added. However, implementations of the present disclosure are not limited thereto.

A cover layer 118 may be disposed on the black matrix BM and in the display area AA. The cover layer 118 may protect the components under the cover layer 118. For example, the cover layer 118 may be made of an organic insulating material. However, implementations of the present disclosure are not limited thereto. For example, the cover layer 118 may be made of a photoresist, polyimide (PI), or a photo acryl-based material. However, implementations of the present disclosure are not limited thereto. For example, the cover layer 118 may be embodied as an overcoat layer, an insulating layer, etc. However, implementations of the present disclosure are not limited thereto.

The polarizing layer 293 may be disposed on the cover layer 118 via a first adhesive layer 291. The cover member 155 may be disposed on the polarizing layer 293 via a second adhesive layer 295. For example, each of the first adhesive layer 291 and the second adhesive layer 295 may include an OCA (Optically clear adhesive), an OCR (Optically clear resin), a PSA (Pressure sensitive adhesive), etc. However, implementations of the present disclosure are not limited thereto.

According to the present disclosure, the plurality of pad electrodes PE may be disposed on the third insulating layer 115c and in the second non-display area NA2. For example, at least a portion of each of the plurality of pad electrodes PE may not be covered with the passivation layer 116 so as to be exposed. For example, the plurality of pad electrodes PE may be electrically connected to the (2-4)-th connection line 122d via a contact hole of the third insulating layer 115c.

An adhesive layer ACF may be disposed on the plurality of pad electrodes PE. The adhesive layer ACF may be an adhesive layer in which conductive balls are dispersed in an insulating material. However, implementations of the present disclosure are not limited thereto. When heat or pressure is applied to the adhesive layer ACF, the conductive balls may be electrically connected to each other in an area to which the heat or pressure has been applied such that the adhesive layer ACF may be conductive. The adhesive layer ACF may be disposed between the plurality of pad electrodes PE and the flexible circuit board (or flexible film) 157 to attach or bond the flexible circuit board (or flexible film) 157 to the plurality of pad electrodes PE. For example, the adhesive layer ACF may be embodied as an anisotropic conductive film (ACF). However, implementations of the present disclosure are not limited thereto.

The flexible circuit board (or flexible film) 157 may be disposed on the adhesive layer ACF. The flexible circuit board (or flexible film) 157 may be electrically connected to the plurality of pad electrodes PE via the adhesive layer ACF. Accordingly, the signals output from the flexible circuit board (or flexible film) 157 and the printed circuit board may be transmitted to the pixel driving circuit PD of the display area AA through the plurality of pad electrodes PE, the (2-4)-th connection line 122d, the (2-3)-th connection line 122c, the (2-2)-th connection line 122b, and the (2-1)-th connection line 122a.

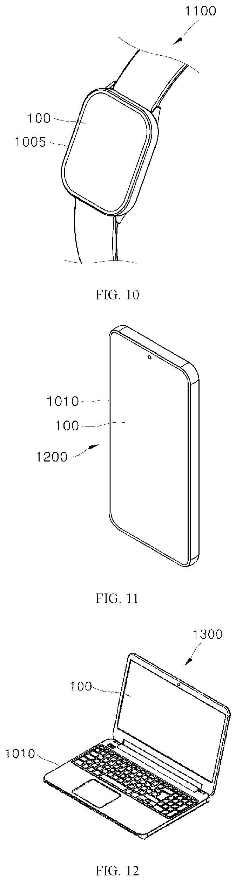

FIGS. 10 to 13 are diagrams illustrating an apparatus to which a display device according to implementations of the present disclosure is applied.

Referring to FIGS. 10 to 13, a display device 1000 according to implementations of the present disclosure may be included in various apparatus or electronic devices. For example, referring to FIGS. 10 to 13, various electronic devices may include a wearable device 1100, a mobile device 1200, a notebook computer 1300, and a monitor or TV 1400. However, implementations of the present disclosure are not limited thereto.

Each of the wearable device 1100, the mobile device 1200, the notebook computer 1300, and the monitor or TV 1400 may include a casing 1005, 1010, 1015, or 1020 and the display device 1000 including the display panel 100 and according to implementations of the present disclosure as described above with reference to FIGS. 1 to 9.

For example, the display device according to an implementation of the present disclosure may be applied to a mobile device, a video phone, a smart watch, a watch phone, a wearable apparatus, a foldable apparatus, a rollable apparatus, a bendable apparatus, a flexible apparatus, a curved apparatus, a sliding apparatus, a variable apparatus, an electronic notebook, an electronic book, a portable multimedia player (PMP), a personal digital assistant (PDA), a MP3 player, a mobile medical device, a desktop PC, a laptop PC, a netbook computer, a workstation, a navigation system, a vehicle display device, a theater display device, a television, a wall paper device, a signage device, a game device, a notebook computer, a monitor, a camera, a camcorder, a home appliance, etc.

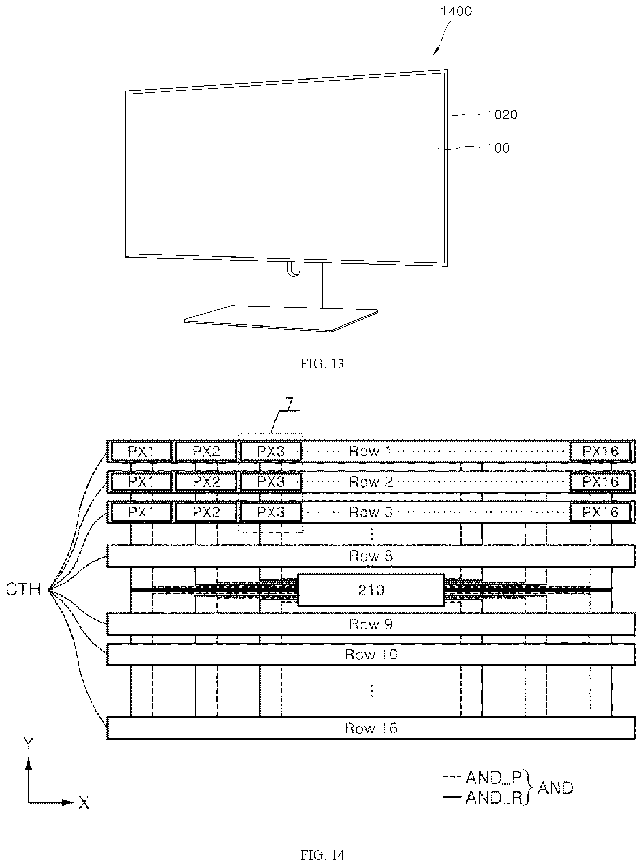

FIG. 14 is a plan view illustrating an area in which one pixel driving circuit among a plurality of pixel driving circuits is disposed.

Referring to FIGS. 3, 5, and 14 together, in a display device according to another implementation of the present disclosure, a plurality of pixels PX1, PX2, PX3...PX16 including a plurality of driving chips 210 as the pixel driving circuits and the plurality of light-emitting elements electrically connected to the driving chips 210 may be arranged.

For example, the first to 16th pixels PX1 to PX16 may be arranged in the row direction as the first direction. One pixel PX may include red (R), green (G), and blue (B) sub-pixels.

A plurality of light-emitting element may be disposed in each of the sub-pixels. At least one light-emitting element may be disposed in one sub-pixel. For example, two light-emitting elements may be disposed in one sub-pixel. One of the two light-emitting elements may act as a main light-emitting element, and the other thereof may act as a redundant light-emitting element. The light-emitting element may be embodied as a micro LED (µLED). Accordingly, the red (R), green (G), and blue (B) sub-pixels may be repeatedly arranged in this order in the first direction, that is, the row direction.

In addition, the sub-pixels emitting light of the same color may be arranged in the column direction as the second direction. For example, the sub-pixels emitting light of one color among red (R), green (G), and blue (B) colors may be arranged in the column direction as the second direction. The sub-pixels emitting light of the same color may be electrically connected to each other through one first electrode AND_P and AND_R.

The first electrode AND may include a first line AND_P and a second line AND_R. The first line AND_P and the second line AND_R may be spaced apart from each other in the first direction DR1 of the substrate 200. The first line AND_P of the first electrode AND may be connected to the main light-emitting element, and the second line AND_R of the first electrode AND may be connected to the redundant light-emitting element.

Each of a plurality of second electrodes CTH may extend in the first direction. In addition, the plurality of second electrodes CTH may be arranged to be spaced apart from each other in the second direction. Accordingly, each of the second electrodes CTH may extend in the first direction and may be connected to the first pixel PX1 to the 16th pixel PX16 arranged in each of a plurality of rows Row 1, Row2, Row 3,..., Row 16.

Each of the plurality of driving chips 210 may include a plurality of driving circuits to drive the plurality of light-emitting elements. One driving chip 210 may be connected to the plurality of first electrodes AND and the plurality of second electrodes CTH respectively connected to the plurality of pixels PX1, PX2, PX3,...,PX16. For example, one driving chip 210 may drive the plurality of light-emitting elements arranged in the first row Row 1 to the 16th row Row16. In other words, one driving chip 210 may be electrically connected to the plurality of light-emitting elements arranged in the first row Row 1 to the 16th row Row 16 through the first electrodes AND and the second electrodes CTH, and may supply a control signal and power thereto through the first electrodes AND and the second electrodes CTH to control the light-emitting operations of the plurality of light-emitting elements.

A display device according to another implementation of the present disclosure operates in a touch sensing manner. The touch sensing manner may include the touch sensing scheme of a capacitance substrate which may include a self-capacitance operation scheme and a mutual capacitance operation scheme for sensing a touch based on a detecting result of a change in a capacitance between two types of touch sensors.

The display device 1000 according to an implementation of the present disclosure may perform the touch operation and the touch sensing in the self-capacitance-based touch sensing scheme, or may perform the touch operation and the touch sensing in the mutual-capacitance-based touch sensing scheme.

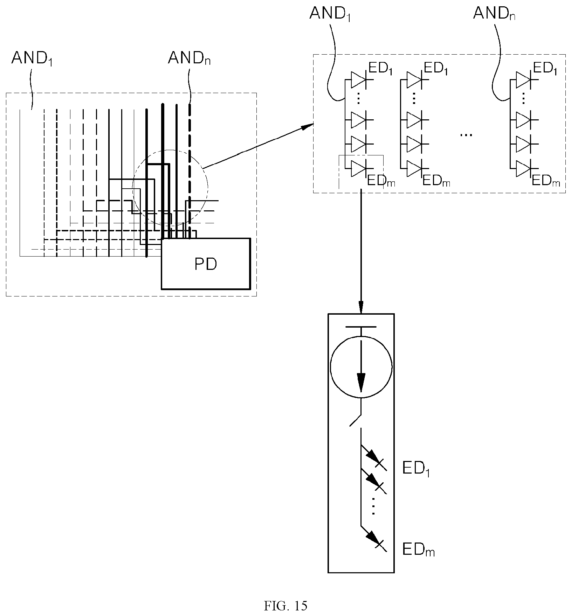

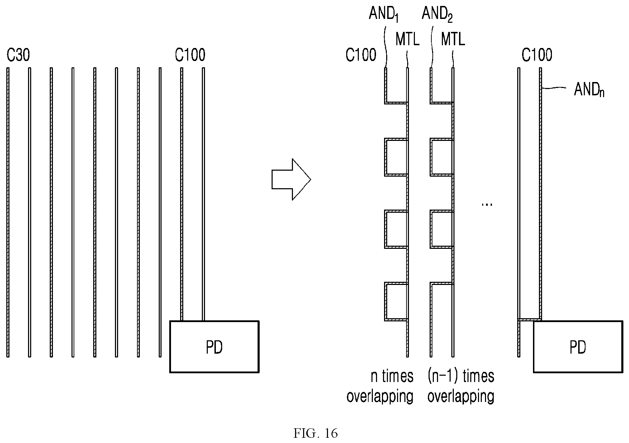

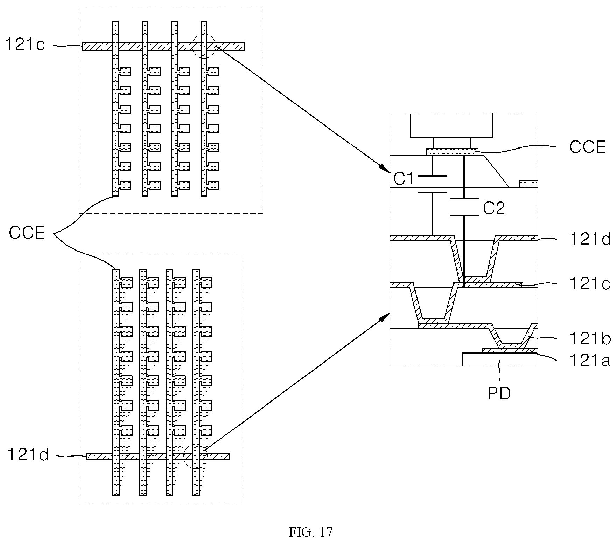

FIG. 15 is a plan view schematically illustrating a configuration of a display device according to a first implementation of the present disclosure. FIG. 16 is a plan view schematically showing an arrangement structure of a driving chip and anode lines in the display device according to the first implementation of the present disclosure. FIG. 17 is a cross-sectional view showing a capacitor structure formed between each of the anode lines and a metal line in the display device according to the first implementation of the present disclosure.

Referring to FIG. 15, in the display device according to the first implementation of the present disclosure, a plurality of anode lines AND1 to ANDn may be disposed in one of opposite sides to each other in a column direction around the pixel driving circuit PD. In addition, although not shown in the drawing, the display device according to the first implementation of the present disclosure may have a structure in which a plurality of anode lines AND1 to ANDn may be disposed in the other of opposite sides to each other in the column direction around the pixel driving circuit PD. In this regard, the pixel driving circuit PD may be a driving chip PD by way of example. Hereinafter, the pixel driving circuit PD may be referred to as the driving chip PD.

One anode line AND1 of the plurality of anode lines AND1 to ANDn connects anode electrodes of the light-emitting elements ED1 to Edm adjacent to each other in a column direction.

Each of the plurality of anode lines AND1 to ANDn extends in the column direction. The plurality of anode lines AND1 to ANDn are arranged in a row direction. Each of the plurality of anode lines AND1 to ANDn may be connected to the driving chip PD.

Referring to FIG. 16, some of the anode lines AND1 and AND2 spaced apart from the driving chip PD by a predetermined distance in the row direction among the plurality of anode lines may be repeatedly bent in a zigzag manner and extend along the column direction. In this regard, the term "being bent" may mean, for example, extending in the column direction and then being bent at a specific angle in a row direction. In one example, the specific angle may be in a range from 80 degrees (°) to 100 degrees (°). In one example, "being bent" may mean extending in the column direction and then being bent at 90 degrees (°) in the row direction. Further, the term "being bent" may mean, for example, extending in the row direction and then being bent at a specific angle in the column direction. In one example, the specific angle may be in a range from 80 degrees (°) to 100 degrees (°). In one example, "being bent" may mean extending in the row direction and then being bent at 90 degrees (°) in the column direction.

The plurality of anode lines may include a first anode line AND1 spaced in the row direction from the driving chip PD by the greatest spacing. The first anode line AND1 extends in the column direction, is bent to the right in the row direction, overlaps a metal line MTL adjacent thereto and disposed in a layer different from a layer of the first anode line, extends along the column direction in an overlapping state, is bent to the left in the row direction, and extends in the column direction. The first anode line AND1 may extend along the column direction while being repeatedly bent and extend in the above manner. For example, the first anode line AND1 may overlap the metal line MTL adjacent thereto and disposed in a layer different from a layer of the first anode line n times, that is, in n segments.

The plurality of anode lines may include a second anode line AND2 spaced in the row direction from the driving chip PD by the next greatest spacing. The second anode line AND2 extends in the column direction, is bent to the right in the row direction, overlaps a metal line MTL adjacent thereto and disposed in a layer different from a layer of the second anode line, extends along the column direction in an overlapping state, is bent to the left in the row direction, and extends in the column direction. The second anode line AND2 may extend along the column direction while being repeatedly bent and extend in the above manner. For example, the second anode line AND2 may overlap the metal line MTL adjacent thereto and disposed in a layer different from a layer of the second anode line (n-1) times, that is, in (n-1) segments.

In this regard, the metal line MTL may be made of the same material as that of the signal line TL and may be disposed in the same layer as the layer of the signal line TL.

The plurality of anode lines AND1 to ANDn may be arranged so as to be spaced from other by a regular spacing along the row direction. The plurality of anode lines AND1 to ANDn may include the outermost anode line spaced apart from the driving chip PD by the greatest predetermined distance to a central anode line positioned at a central position of the driving chip PD.

Each of the anode lines arranged so as to be spaced from other by a regular spacing along the row direction and arranged from the outermost side to the central position of the driving chip PD may be repeatedly bent in a zigzag manner and extend along the column direction.

Capacitance values respectively generated between the anode lines arranged so as to be spaced from other by a regular spacing along the row direction and arranged from the outermost side to the central position of the driving chip PD and the corresponding metal lines adjacent to and disposed in the different layers from the layers of the anode lines may be uniform.

For example, when the capacitance value generated between an n-th anode line ANDn disposed at the central position of the driving chip PD or the n-th anode line ANDn close to the central position of the driving chip PD and the corresponding metal line is C100, the capacitance value generated between the outermost first anode line AND1 disposed at the outermost side and spaced apart from the driving chip PD by the greatest distance in the row direction and the corresponding metal line may also be C100.

In an implementation of the present disclosure, when the capacitance value between the first anode line AND1 disposed at the outermost side and extending not in the zigzag but in the straight manner and the corresponding metal line is C30, the capacitance value between the first anode line AND1 disposed at the outermost side and extending in the zigzag manner according to an implementation of the present disclosure and the corresponding metal line is increased to C100, and thus is equal to the capacitance value between the n-th anode line ANDn located at the central area and the corresponding metal line, so that the difference between the capacitance values across all of the anode lines and the corresponding metal lines in an entire display area does not occur.

Accordingly, the difference between the capacitance values across all of the anode lines and the corresponding metal lines in an entire display area does not occur, thereby preventing the luminance variation, and thus preventing a vertical line mura from being visible.

Among the plurality of anode lines, the anode line adjacent to the anode line extending in the zigzag manner in the row direction and overlapping the anode line extending in the zigzag manner may be disposed in a different layer from a layer of the anode line extending in the zigzag manner.

Among the plurality of anode lines arranged so as to be spaced from each other by an equal spacing in the row direction, the anode lines disposed in the same layer may be repeatedly bent in the zigzag manner and extend along the column direction .

Each capacitor may be formed between each portion of the anode line repeatedly bent in the zigzag manner and extending along the column direction and each portion of the metal line adjacent thereto and overlapping each portion of the anode line.

For example, as illustrated in FIG. 17, a first signal line or metal line 121d may be disposed in one of the opposite sides to each other in the column direction around the driving chip PD. The plurality of anode lines AND1 to ANDn extending in the column direction may be arranged so as to be spaced from each other along the row direction. Each of the plurality of anode lines AND1 to ANDn may contact each of the plurality of contact electrodes CCE. Thus, each of the plurality of anode lines may be referred to as the anode line CCE. A second signal line or metal line 121c may be disposed in the other of the opposite sides to each other in the column direction around the driving chip PD.

Accordingly, a first capacitor C1 may be formed between the first signal line 121d disposed on the second insulating layer 115b and the anode line CCE disposed on the third insulating layer 115c. In addition, a second capacitor C2 may be formed between the second signal line 121c disposed on the first insulating layer 115a and the anode line CCE disposed on the third insulating layer 115c.

In a case where each of the first capacitor C1 and the second capacitor C2 has a dielectric material other than a free space between both opposite electrode plates, the magnitude of the capacitance may be proportional to a dielectric constant of the dielectric material.

Respective capacitance values between the plurality of anode lines AND1 to ANDn and the single line in one of the opposite sides to each other in the column direction around the driving chip PD may be uniform. Respective capacitance values between the plurality of anode lines AND1 to ANDn and the single line in the other of the opposite sides to each other in the column direction around the driving chip PD may be uniform.

The plurality of anode lines AND1 to ANDn extending in the column direction may be arranged so as to be spaced from each other by the equal spacing along the row direction. The anode line may be one of the plurality of contact electrodes CCE disposed on the third insulating layer 115c in the display area AA.

The metal lines 121c and 121d may be disposed in different layers. The metal line 121d may be one of the plurality of (1-4)-th connection lines 121d disposed on the second insulating layer 115b. The metal line 121c may be one of the plurality of (1-3)-th connection lines 121c disposed on the first insulating layer 115a. However, an implementation of the disclosure is not limited thereto.

For example, one of the plurality of (1-4)-th connection lines 121d disposed on the second insulating layer 115b may be an anode line, and one of the plurality of (1-3)-th connection lines 121c disposed on the first insulating layer 115a may also be an anode line.

Therefore, each capacitor may be generated between each portion of the anode line which is repeatedly bent in the zigzag manner and extends along the column direction and each portion of another anode line disposed in the different layer from the layer of the anode line extending in the zigzag manner and adjacent thereto and overlapping with each portion of the anode line extending in the zigzag manner.

The anode lines repeatedly bent in a zigzag manner and extending along the column direction may be constructed that the number of times the anode line is bent increases as the anode lines are arranged in a direction from the center position of the driving chip PD toward the outermost side.

Accordingly, among the anode lines repeatedly bent in the zigzag manner and extending along the column direction, the number of times the outermost anode line is bent may be the largest, while the number of times the anode line close to the center position of the driving chip PD is bent may be the smallest.

The number of times each anode line is bent may mean the number of times each anode line overlaps the metal line adjacent thereto and disposed in a different layer from a layer of each anode line or the number of areas in which each anode line overlaps the metal line adjacent thereto and disposed in a different layer from a layer of each anode line. Further, the number of times each anode line overlaps the metal line adjacent thereto and disposed in a different layer from a layer of each anode line or the number of areas in which each anode line overlaps the metal line adjacent thereto and disposed in a different layer from a layer of each anode line may mean the number of capacitors generated between each anode line and the metal line adjacent thereto and disposed in a different layer from a layer of each anode line.

Accordingly, among the anode lines that are repeatedly bent in a zigzag manner and extend along the column direction, the outermost anode line may generate the largest number of capacitors with respect to the metal line or another anode line adjacent thereto and disposed in a different layer from a layer of the outermost anode line. Further, the central anode line close to the center position of the driving chip PD may generate the smallest number of capacitors with respect to the metal line or another anode line adjacent thereto and disposed in a different layer from a layer of the central anode line.

In general, each of some of the plurality of anode lines AND1 to ANDn may generate a capacitance value that is different from an average capacitance value which the anode line in the central area may generate by a predetermined or greater, due to the capacitive coupling with the metal line disposed in the different layer from the layer of the anode line and overlapping therewith. However, according to an implementation of the present disclosure, each of some of the plurality of anode lines AND1 to ANDn which generates the capacitance value different from an average capacitance value which the anode line in the central area may generate by a predetermined or greater, may extend along the column direction so as to be repeatedly and many times bent in a zigzag manner, such that each time the anode line is bent, each capacitor may be generated between each bent portion thereof and each portion of the metal line overlapping therewith. This may increase the capacitive coupling amount, and thus, the total capacitance which each of the plurality of anode lines may generate may be substantially equal to the average capacitance value. Therefore, the capacitance difference does not occur, such that the mura may be prevented from being visually recognized during the light emission operation of the light-emitting elements.

In the display device according to an implementation of the present disclosure, the influence of the anode voltage resulting from the coupling due to a short operation time of the driving chip PD is significantly greater than that in a conventional OLED display device or LCD display device. In addition, visibility of the mura may be greater in the monochromatic light emission operation.

In the display device according to an implementation of the present disclosure, the anode line generating a capacitance value that is different from an average capacitance value may be repeatedly bent in the zigzag manner and extend along the column direction so as to repeatedly overlap the metal line adjacent thereto, thereby compensating for the capacitive coupling difference, thereby preventing the mura from being visually recognized by the user in the low grayscale operation of the light-emitting elements.

The driving chip PD according to an implementation of the present disclosure may control the light emission operation of each of the plurality of light-emitting elements according to a Pulse Width Modulation (PWM) manner.

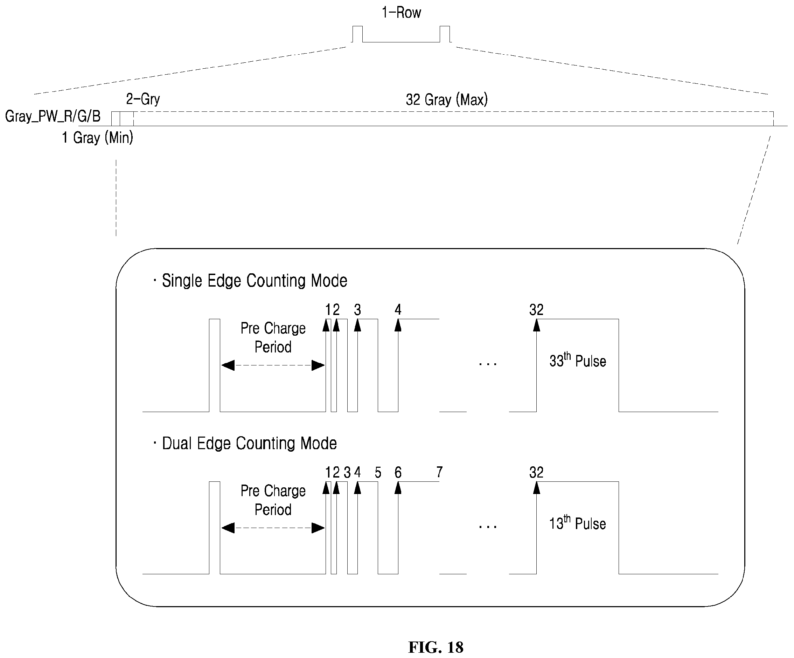

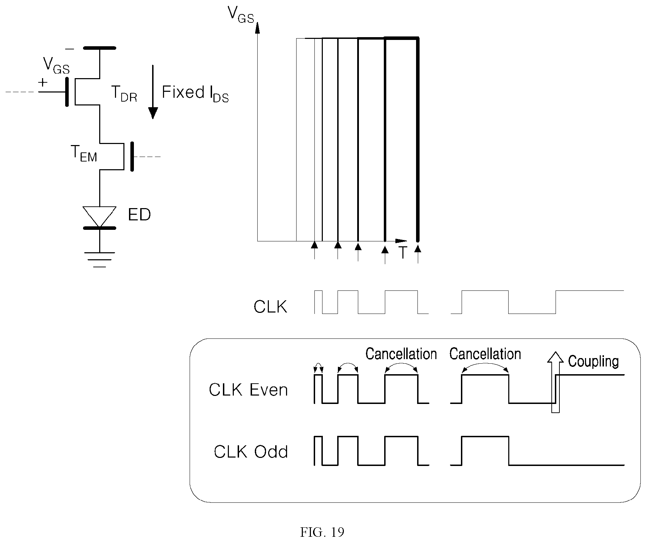

As shown in FIGS. 18 to 20, the driving chip PD may control an application time of a light emission signal to one light-emitting element based on a pulse width W. FIGS. 19 to 20 are diagrams illustrating an example in which the driving chip controls a light-emitting operation of a light-emitting element in the PWM manner according to an implementation of the present disclosure.

Referring to FIG. 18, for example, the driving chip PD may adjust the pulse width PW of one pulse signal from a minimum of 1 gray to a maximum of 32 gray.

Referring to FIG. 19, the driving chip PD may apply the pulse width modulation (PWM) signal to the gate electrode of the light-emission transistor T_{EM}.

Accordingly, fixed emission current (Fixed I_{DS}) is applied to the light-emitting element ED through the light-emission transistor T_{EM}, so that the light-emitting element ED may emit light.

For example, when eight light-emitting elements are connected to one anode line, all of the eight light-emitting elements emit light based on the fixed current (Fixed I_{DS}) having the same current value. In the OLED display device, the different voltages are applied to the gate electrodes of the different light-emission transistors such that different amounts of current flow through different light-emitting elements, and the current flows through the different light-emitting elements for the same time duration. However, in the display device according to an implementation of the present disclosure, the same voltage is applied to the gate electrodes of the different light-emission transistors such that the same amount of current flows through the different light-emitting elements, and the current flows through the different light-emitting elements for different time durations, respectively. That is, the time duration for which the current flows through each of the light-emitting elements is adjusted based on the pulse width of the PWM signal.

In FIG. 18, the PWM signal may be provided in each of a single edge counting mode and a dual edge counting mode. In each operation mode, after a pre-charge period, the PWM signal having the adjusted pulse width may be applied to the gate electrode of the light-emission transistor T_{EM}.

When one light-emitting element operates, for example, 33 pulse signals may be applied in the single edge counting mode, and 13 pulse signals may be applied in the dual edge counting mode.

The plurality of light-emitting elements are connected to the anode lines disposed in one of the opposite sides to each other in the column direction around the driving chip PD, and are connected to the anode lines disposed in the other of the opposite sides to each other in the column direction around the driving chip PD, and may perform a light-emitting operation based on the PWM signal applied thereto under the control of the driving chip PD.

As shown in FIG. 19, the driving chip PD may apply an even clock signal CLK to the anode lines disposed in the other of the opposite sides to each other in the column direction around the driving chip PD and may apply an odd clock signal CLK to the anode lines disposed in one of the opposite sides to each other in the column direction around the driving chip PD according to the PWM manner. FIG. 19 is a diagram illustrating an example in which a driving chip according to an implementation of the present disclosure supplies a clock signal according to an PWM manner. Accordingly, the plurality of light-emitting elements connected to the anode lines disposed in the other of the opposite sides to each other in the column direction around the driving chip PD may operate based on the even clock signal CLK, while the plurality of light-emitting elements connected to the anode lines disposed in one of the opposite sides to each other in the column direction around the driving chip PD may operate based on the odd clock signal.

In this regard, each of the anode lines disposed in the other of the opposite sides to each other in the column direction around the driving chip PD may be repeatedly bent in the zigzag manner and extend along the column direction so as to repeatedly overlap the metal line adjacent thereto and disposed in the different layer from the layer of the anode line. Thus, each of the first capacitors C1 may be formed between each of the anode lines and the metal line in each area in which each of the anode lines and the metal line overlap each other vertically.

While the anode lines disposed in the other of the opposite sides to each other in the column direction around the driving chip PD receive the even clock signal CLK from the driving chip PD, the anode voltage may increase due to the capacitive coupling with the single line at a rising edge of the clock signal, thereby suppressing the variation in the luminance between light-emitting elements connected to the anode lines disposed in the other of the opposite sides to each other in the column direction around the driving chip PD. Thus, the capacitive coupling difference between the anode lines and the metal lines may be compensated for to prevent the mura.

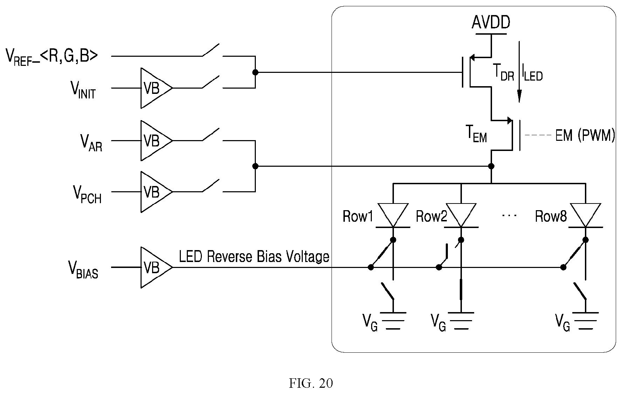

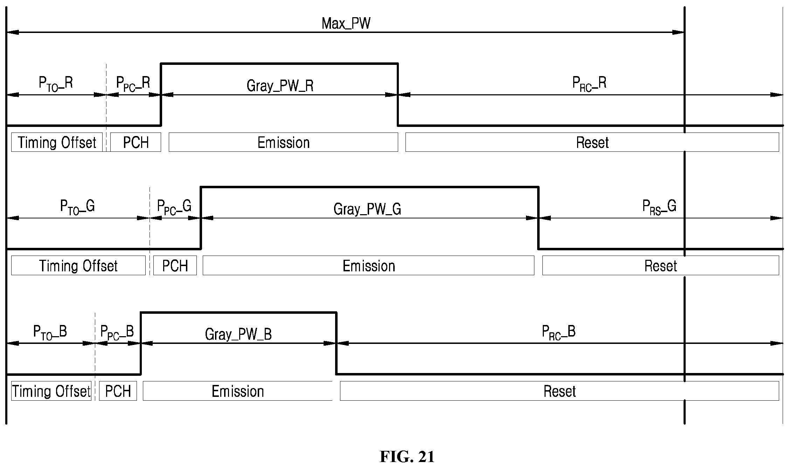

FIG. 20 is a diagram illustrating an example of a pixel circuit according to an implementation of the present disclosure, and FIG. 21 is a signal waveform diagram of a PWM signal according to an implementation of the present disclosure.

Referring to FIG. 20, a pixel circuit according to an implementation of the present disclosure may include the driving transistor T_{DR}, the light-emission transistor T_{EM}, and a plurality of light-emitting elements Row1, Row2, ..., Row8.

The high potential voltage AVDD may be applied to one electrode of the driving transistor T_{DR}, the light-emission transistor T_{EM} may be connected to the other electrode of the driving transistor T_{DR}, and the reference voltage V_{REF} or the initialization voltage V_{INT} may be applied to the gate electrode of the driving transistor T_{DR}. The reference voltage V_{REF} may be applied to the gate electrode of the driving transistor T_{DR} through a switching means, or the initialization voltage V_{INT} may be applied thereto through a voltage buffer V_{B} and then a switching means.

The reference voltage V_{REF} may have one voltage within a range of, for example, -0.75V to 1.29V. For example, the reference voltage V_{REF} of 0.34V may be applied to the red (R) light-emitting element, 0.80V may be applied to the green (G) light-emitting element, and 0.65V may be applied to the blue (B) light-emitting element.

The driving transistor T_{DR} may be connected to one electrode of the light-emission transistor T_{EM}, each of the light-emitting elements Row1, Row2, ..., Row8 may be connected to the other electrode of the light-emission transistor T_{EM}, and a light-emission signal EM(PWM) may be applied to a gate electrode thereof.

An anode reset voltage V_{AR} or a precharge voltage V_{PCH} may be applied to one electrode of each of the light-emitting elements Row1, Row2, ..., Row8.

The anode reset voltage V_{AR} may be applied to one electrode of each of the light-emitting elements Row1, Row2, ..., Row8 through the voltage buffer V_{B} and then a switching means.

The anode reset voltage V_{AR} may be determined within a range of a voltage obtained by adding 0V to 4.6V to a ground voltage V_{G}. For example, the anode reset voltage VAR may be a voltage obtained by adding 1.0V to the ground voltage V_{G}.

The precharge voltage V_{PCH} may be applied to one electrode of each of the light-emitting elements Row1, Row2, ..., Row8 through the voltage buffer V_{B} and then a switching means.

The precharge voltage V_{PCH} may be determined within a range of a voltage obtained by adding 0V to 5.1V to the ground voltage V_{G}. For example, a precharge voltage VPCH obtained by adding 1.0V to the ground voltage V_{G} may be applied to the red (R) light-emitting element, a precharge voltage V_{PCH} obtained by adding 1.5V to the ground voltage V_{G} may be applied to the green (G) light-emitting element, and a precharge voltage V_{PCH} obtained by adding 1.5V to the ground voltage V_{G} may be applied to the blue (B) light-emitting element.

The precharge voltage V_{PCH} is not limited thereto. For example, a precharge voltage VPCH obtained by adding 1.5V to 1.9V to the ground voltage V_{G} may be applied to the red (R) light-emitting element, a precharge voltage V_{PCH} obtained by adding 2.0V to 2.4V to the ground voltage V_{G} may be applied to the green (G) light-emitting element, and a precharge voltage V_{PCH} obtained by adding 2.2V to 2.6V to the ground voltage V_{G} may be applied to the blue (B) light-emitting element. The ground voltage V_{G} may have a negative voltage within a range of, for example, -5.018V to -2.50V. For example, the ground voltage V_{G} may be minus 4.7 volts (-4.70V).

A bias voltage V_{BIAS} may be applied to the other electrode of each of the light-emitting elements Row1, Row2, ..., Row8 through the voltage buffer V_{B} and then a switching means. In this regard, the bias voltage V_{BIAS} may be, for example, a LED reverse bias voltage. The bias voltage V_{BIAS} may be, for example, a voltage of 1.30V.

Referring to FIG. 21, a PWM signal Max_PW according to an implementation of the present disclosure may include a timing offset period (Period for Timing Offset) P_{TO}, a precharge period (Period for Precharge) P_{PC}, a light emission period Gray_PW, and a reset period (Period for Reset) P_{RS}.

The PWM signal Max_PW shown in FIG. 21 may be, for example, an PWM signal Max_PW corresponding to a maximum period in one frame.

Each of the light emission period Gray_PW_R of red (R) color, the light emission period Gray_PW_G of green (G) color, and the light emission period Gray_PW_B of blue (B) color may has a signal of a high level. Each of the timing offset period P_{TO}, the precharge period P_{PC}, and the reset period P_{RS} may have a signal of a low level.

The plurality of light-emitting elements may include a first light-emitting element for red (R) light emission, a second light-emitting element for green (G) light emission, and a third light-emitting element for blue (B) light emission.

As shown in FIG. 21, the driving chip PD according to an implementation of the present disclosure may control the first light-emitting element for red (R) light emission, the second light-emitting element for green (G) light emission, and the third light-emitting element for blue (B) light emission such that the third light-emitting element (B) emits light first, then the first light-emitting element (R) emits light, and then the second light-emitting element (G) emits light.

For example, as shown in FIG. 21, the light emission periods of the light-emitting elements may be configured such that the blue (B) emission period Gray_PW_B first occurs, followed by the red (R) emission period Gray_PW_R, and followed by the green (G) emission period Gray_PW_G.

The light emission periods of the light-emitting elements may be configured such that the emission period Gray_PW_G of green (G) is the longest, the emission period Gray_PW_B of blue (B) is the shortest, and the emission period Gray_PW_R of red (R) is therebetween.

The timing offset periods P_{TO} of the light-emitting elements may be configured such that the timing offset period P_{TO_}G of the green (G) light-emitting element is the longest, the timing offset period P_{TO_}B of the blue (B) light-emitting element is the shortest, and the timing offset period P_{TO_}R for the red (R) light-emitting element is therebetween.

The precharge period P_{PC}s of the light-emitting elements may be configured such that the precharge period P_{PC_}B of the blue (B) light-emitting element starts first, followed by the precharge period P_{PC_}R of the red (R) light-emitting element starts, and followed by the precharge period P_{PC_}G for the green (G) light-emitting element. However, the precharge periods P_{PC_}B, P_{PC}_R, and P_{PC_}G of the light-emitting elements have the same time length.

The reset periods P_{RS} of the light-emitting elements may be configured such that the reset period P_{RS_}B of the blue (B) light-emitting element is the longest, the reset period P_{RS_}G of the green (G) light-emitting element is the shortest, and the reset period P_{RS_}R of the red (R) light-emitting element is therebetween.

The light-emitting element of blue (B) color may first start the light-emitting operation Gray_PW_B, then, the light-emitting element of red (R) color may start the light-emitting operation Gray_PW_R, and then, the light-emitting element of green (G) color may start the light-emitting operation Gray_PW_G. However, the light-emitting element of green (G) color has the longest light-emitting period Gray_PW_G, and thus may end the light-emitting operation last.

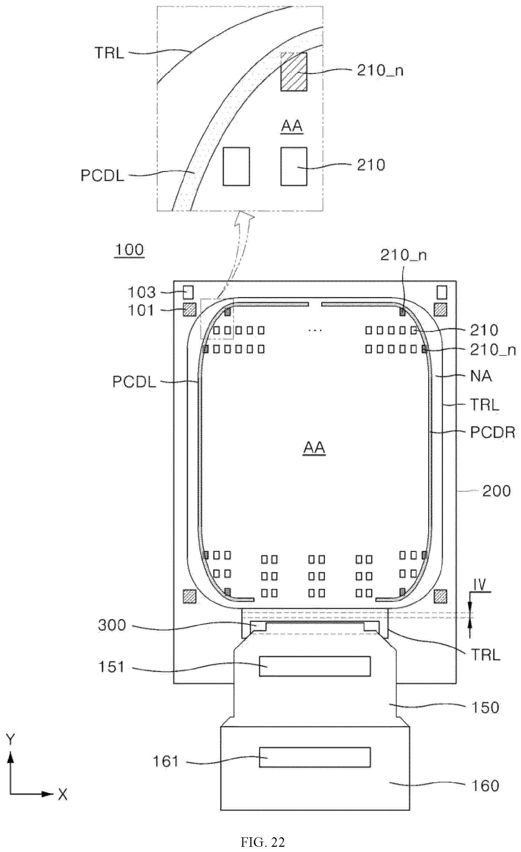

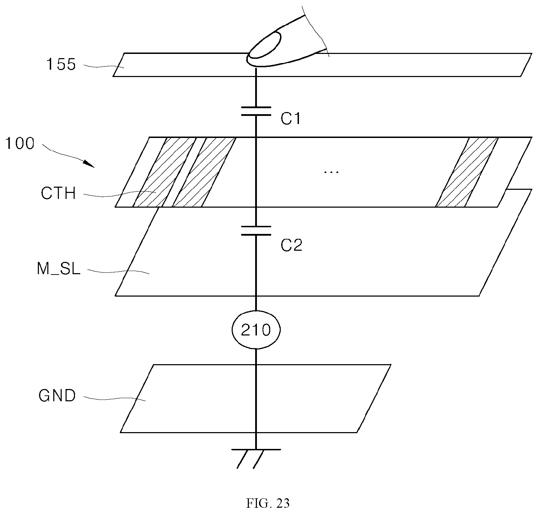

FIG. 22 is a plan view of a display device according to another implementation of the present disclosure. FIG. 23 is a view illustrating a touch operation of a display device according to another implementation of the present disclosure.

Referring to FIG. 22, in a display area AA of a substrate 200 according to another implementation of the present disclosure, a plurality of pixels PX1, PX2, PX3, ...., PX16 including a plurality of driving chips 210 as the pixel pixel driving circuits PD and a plurality of light-emitting elements electrically connected to the driving chips 210 may be arranged. Each driving chip 210 may supply a control signal and power to the plurality of light-emitting elements to control a light-emitting operation of the plurality of light-emitting elements.

The substrate 200 may have a shape in which a length of one side is larger than a length of the other side. For example, the substrate 200 may include a long side having a larger length and a short side having a smaller length than that of the long side. The short side may extend in the first direction X of the substrate 200, and the long side may extend in the second direction Y of the substrate 200. However, implementations of the present disclosure are not limited thereto.

One or more crack detection lines PCDL and PCDR may be disposed in a partial area of the non-display area NA. Each of the one or more crack detection lines PCDL and PCDR may extend along a peripheral area of the display area AA and may detect a defect such as a crack that may occur in the peripheral area of the display area AA. The one or more crack detection lines PCDL and PCDR may extend along at least both opposing sides and a portion of each of upper and the other of the opposite sides to each other in the column direction around the driving chip PDs of the display area AA. For example, the one or more crack detection lines PCDL and PCDR may include a first crack detection line PCDL and a second crack detection line PCDR.

The first crack detection line PCDL may extend along a left long side of the substrate 200 and may extend to each of upper and lower left corners and then may extend along a left portion of each of upper and lower short sides. The second crack detection line PCDR may extend along a right long side of the substrate 200 and may extend to each of upper and lower right corners and then may extend along a right portion of each of the upper and lower short sides. The first crack detection line PCDL and the second crack detection line PCDR may be spaced apart from each other.

Each of the first crack detection line PCDL and the second crack detection line PCDR may be disposed to overlap some of the plurality of driving chips 210 at each corner area. The driving chip 210 disposed to overlap the first and second crack detection lines PCDL and PCDR in the corner area may be an inactive driving chip 210_n.

The inactive driving chip 210_n may be disposed to overlap the first crack detection line PCDL or the second crack detection line PCDR at the corner area of the substrate 200, and thus may not be electrically connected to at least a portion of the power line or the signal line. Accordingly, the inactive driving chip 210_n may be an unused driving chip that does not control the plurality of light-emitting elements. The inactive driving chip 210_n may include at least eight driving chips arranged along the four corner areas of the substrate 200 among the plurality of driving chips 210. For example, two inactive driving chips 210_n may be disposed in each of the four corner areas of the substrate 200.

The substrate 200 may include a trimming line TRL extending along a peripheral area of the non-display area NA. The trimming line TRL may be a cutting line cut by a laser beam during a scribing process for dividing the substrate 200 into a plurality of display panels 100 (see FIG. 1) as individual units. An area disposed outwardly of the trimming line TRL may be removed in the scribing process.

A plurality of alignment key patterns 101 and 103 may be disposed in the area disposed outwardly of the trimming line TRL. The plurality of alignment key patterns 101 and 103 may include a first alignment key pattern 101 and a second alignment key pattern 103. However, implementations of the present disclosure are not limited thereto. Since the plurality of alignment key patterns 101 and 103 are disposed in the area disposed outwardly of the trimming line TRL, they may be removed in the scribing process.

The first alignment key pattern 101 may be a pattern for alignment between the display panel 100 and the cover member 155 of FIG. 1. At least one of the plurality of first alignment key patterns 101 may be positioned in the area disposed outwardly of the trimming line TRL facing each corner area of the substrate 200. For example, each first alignment key patterns101 may be disposed at each of four corner areas of the substrate 200. Thus, the plurality of first alignment key patterns 101 may include four alignment key patterns.

The second alignment key pattern 103 may include various alignment key patterns for aligning components respectively disposed in different layers, such as a plurality of signal lines, contact holes, and a plurality of driving chips disposed on the substrate 200 at correct positions. The second alignment key pattern 103 may include a metal material. Accordingly, the second alignment key pattern 103 may be disposed on the display area AA or the non-display area NA and may be formed at the same time as a time at which a plurality of signal lines including a metal material is formed. However, implementations of the present disclosure are not limited thereto.

The plurality of driving chips 210 as the pixel driving circuits may be disposed on the display area AA of the substrate 200. For example, the plurality of driving chips 210 may be arranged in a matrix shape. However, implementations of the present disclosure are not limited thereto.

Each of the plurality of driving chips 210 may include a plurality of driving circuits to drive the plurality of light-emitting elements. One driving chip 210 may be connected to the plurality of first electrodes AND and the plurality of second electrodes CTH respectively connected to the plurality of pixels PX1, PX2, PX3,...,PX16. For example, one driving chip 210 may drive the plurality of light-emitting elements arranged in the first row Row1 to the 16th row Row16. In other words, one driving chip 210 may be electrically connected to the plurality of light-emitting elements arranged in the first row Row 1 to the 16th row Row 16 through the first electrodes AND and the second electrodes CTH, and may supply a control signal and power thereto through the first electrodes AND and the second electrodes CTH to control the light-emitting operations of the plurality of light-emitting elements.

The display device according to an implementation of the present disclosure may have an in-cell touch structure in which each of the plurality of second electrodes CTH is used as a touch electrode instead of forming a separate touch electrode. Accordingly, since the separate touch electrode is not formed, a thickness of the display panel may be reduced.

Referring to FIG. 23, when a user's touch operation is performed on the cover member 155, a change in a first capacitance C1 between each of the plurality of second electrodes CTH disposed on the substrate of the display panel 100 and the cover member 155 and a change in a second capacitance C2 between each of the plurality of second electrodes CTH and each of a plurality of signal lines M_SL may be detected and provided to the driving chip 210. In addition, the driving chip 210 may perform a touch control function to provide a control signal based on the touch input to the plurality of light-emitting elements. A ground GND may be disposed to be opposite to the cover member 155 while the plurality of second electrodes CTH are disposed between the cover member and the ground.

A touch sensing scheme of a capacitance substrate may include a self-capacitance operation scheme and a mutual capacitance operation scheme for sensing a touch based on a detecting result of a change in a capacitance between two types of touch sensors.

The display device 1000 according to an implementation of the present disclosure may perform the touch operation and the touch sensing in the self-capacitance-based touch sensing scheme, or may perform the touch operation and the touch sensing in the mutual-capacitance-based touch sensing scheme.

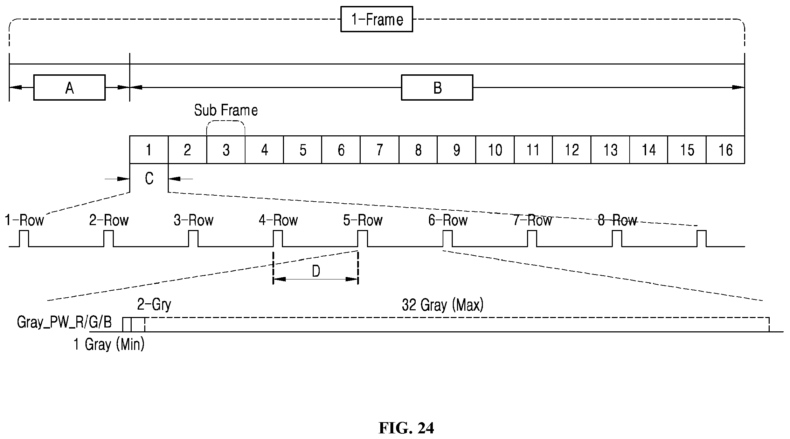

FIG. 24 illustrates an example of a signal waveform diagram when a display device according to an implementation of the present disclosure operates.

Referring to FIG. 24, the display device according to an implementation of the present disclosure may perform a light emission operation on one frame basis.

One frame may include a touch period A and a display period B.

One frame may operate at a frequency of, for example, 60 Hz. In this case, the touch period A may operate for a first time duration at a frequency of, for example, 60 Hz, and the display period B may operate for a second time duration larger than the first time duration at a frequency of, for example, 60 Hz. Accordingly, the operation time duration of the touch period A and the operation time duration of the display period B in one frame may be different from each other. For example, the operation time duration of the touch period A may be shorter than the operation time duration of the display period B.

The display period B may include 16 sub-frames.

For example, when, in the display panel, eight light-emitting elements are connected to one anode electrode line as the first electrode, one sub-frame period C may include eight pulse signals 1-Row, 2-Row, 3-Row, 4-Row, 5-Row, 6-Row, 7-Row, and 8-Row. That is, in an implementation of the present disclosure, eight micro light-emitting elements (µLED) may operate during one sub frame.

Accordingly, in an implementation of the present disclosure, one frame includes 16 sub-frames and one sub-frame includes 8 pulse signals, such that 128 micro light-emitting elements (µLED) may operate for one frame.

An implementation of the present disclosure is not limited thereto. For example, when 16 micro light-emitting elements (µLED) are connected to one anode electrode line as the first electrode, one sub-frame period C may include 16 pulse signals. In this case, 256 micro light-emitting elements (µLED) may operate for one frame.

One pulse signal (e.g., 5-Row) drives one micro light-emitting element (µLED). One pulse signal period D may include a high signal period and a low signal period. In this regard, a time duration of the low signal period may be larger than a time duration of the high signal period.

In an implementation of the present disclosure, an operation time duration of the micro light-emitting element (µLED) may be controlled based on a light-emission signal EM applied to the gate electrode of the light-emission transistor T_{EM}.

A micro driver (µDriver) may control an application time duration of the light-emission signal EM based on a pulse width PW. For example, a case in which one pulse signal (e.g., 5-Row) is applied to the gate electrode of the light-emission transistor T_{EM} using one pulse width PW may be referred to as one gray.

In order to control the application time duration of the light-emission signal EM, the micro driver (µDriver) may apply one pulse signal (e.g., 5-Row) using the pulse width PWvarying from a minimum of 1 Gray (Min) to a maximum of 32 Gray (Max).

One pixel PX may include red (R), green (G), and blue (B) sub-pixels. Each of the plurality of micro light-emitting elements (µLED) may be disposed in the sub-pixel.

Accordingly, the micro driver (µDriver) may control a light-emission time duration of the micro light-emitting element (µLED) corresponding to each of red (R), green (G), and blue (B) sub-pixels by applying the pulse signal of which the pulse width PW is adjusted from a minimum of 1 Gray (Min) to a maximum of 32 Gray (Max) to the gate electrode of the light-emission transistor T_{EM}.

As described above, according to an implementation of the present disclosure, the anode line generating a capacitance value different from an average capacitance value during the low-gray light emission operation of the light-emitting elements in the display area may be repeatedly bent in the zigzag manner and extend along the column direction so as to repeatedly overlap the metal line adjacent thereto, such that each time the anode line is bent, each capacitor may be generated between each bent portion thereof and each portion of the metal line overlapping therewith. This may increase the capacitive coupling amount, and thus, the total capacitance which each of the plurality of anode lines may generate may be substantially equal to the average capacitance value. Therefore, the capacitance difference does not occur, such that the mura may be prevented from being visually recognized during the light emission operation of the light-emitting elements.

According to an implementation of the present disclosure, the difference between the capacitances between the respective anode lines and the metal line in the display area may be suppressed.

According to an implementation of the present disclosure, the display device capable of preventing the mura from being visually recognized by the user by preventing the capacitance difference from occurring in the low grayscale light-emission operation of the light-emitting elements in a display area may be realized.

According to an implementation of the present disclosure, the difference between the capacitances between the lines for the light-emitting elements in the display area is canceled to prevent the mura from being recognized, thereby preventing a luminance variation during a light-emitting operation.

According to an implementation of the present disclosure, the display device may reduce the power consumption for the light emission by preventing the luminance variation of the display area.

According to an implementation of the present disclosure, as the power consumption of the light-emitting element is reduced, decrease in the lifespan of the display device may be prevented.

In addition, according to an implementation of the present disclosure, a display device capable of reducing the power consumption of the light-emitting element to increase the lifespan of the display panel and of improving the quality of the display device may be provided.

Furthermore, according to an implementation of the present disclosure, a display device capable of securing product reliability by improving the luminance variation of the light-emitting elements may be provided.

According to an implementation of the present disclosure, the power consumption of the light-emitting element is reduced, and decrease in the lifespan of the display device is prevented, thereby providing a long-lifespan and low power consuming display device.

According to an implementation of the present disclosure, as the power consumption of the light-emitting element is reduced, the decrease in the lifespan of the display panel may be reduced, and quality improvement of the display device may be implemented.

The display device according to various aspects and implementations of the present disclosure may be described as follows.

A first aspect of the present disclosure provides a display device comprising: a substrate including a display area and a non-display area; a pixel driving circuit disposed on the display area of the substrate; a plurality of light-emitting elements disposed on the display area of the substrate, wherein the plurality of light-emitting elements are electrically connected to the pixel driving circuit; and a plurality of anode lines extending in a column direction and arranged in a row direction, wherein each anode line connects anode electrodes of light-emitting elements arranged so as to be adjacent to each other in the column direction among the plurality of light-emitting elements to each other, wherein each of some of the plurality of anode lines spaced apart from the pixel driving circuit by a predetermined distance in the row direction is repeatedly bent in a zigzag manner and extends along the column direction.

In accordance with some implementations of the first aspect of the present disclosure, the plurality of anode lines are arranged so as to be spaced from each other by an equal spacing in the row direction, wherein the plurality of anode lines includes an outermost anode line spaced from the pixel driving circuit by a greatest spacing in the row direction, and a central anode line positioned at a central position of the pixel driving circuit.

In accordance with some implementations of the first aspect of the present disclosure, each of the plurality of anode lines including the outermost anode line to the central anode line arranged so as to be spaced from each other by the equal spacing in the row direction is repeatedly bent in the zigzag manner and extends along the column direction.

In accordance with some implementations of the first aspect of the present disclosure, all of capacitances respectively generated by the plurality of anode lines including the outermost anode line to the central anode line arranged so as to be spaced from each other by the equal spacing in the row direction have substantially the same value.

In accordance with some implementations of the first aspect of the present disclosure, the plurality of anode lines include an anode line adjacent to the anode line repeatedly bent in the zigzag manner in the row direction and extending along the column direction, wherein the adjacent anode line and the anode line repeatedly bent in the zigzag manner and extending along the column direction overlap each other and are disposed in different layers.

In accordance with some implementations of the first aspect of the present disclosure, each of the anode lines disposed in the same layer among the plurality of anode lines arranged so as to be spaced from each other by the equal spacing in the row direction is repeatedly bent in the zigzag manner and extends along the column direction.

In accordance with some implementations of the first aspect of the present disclosure, each of the anode lines repeatedly bent in the zigzag manner and extending along the column direction overlap a corresponding metal line adjacent to each anode line and disposed in a different layer from a layer of each anode line, wherein each anode line is repeatedly bent multiple times in the zigzag manner so as to overlap the corresponding metal line in multiple areas, wherein each capacitor is generated between the anode line and the metal line in each of the multiple areas.

In accordance with some implementations of the first aspect of the present disclosure, a number of bent times of the bent anode lines is increases from a center position of the pixel driving circuit to the outermost of the substrate.

In accordance with some implementations of the first aspect of the present disclosure, among the bent anode lines a number of bent times of the outermost anode line is a largest, and a number of bent time of the central anode line disposed at the center position of the pixel driving circuit is a smallest.

In accordance with some implementations of the first aspect of the present disclosure, among the bent anode lines the outermost anode line generates a largest number of capacitors with respect to the corresponding metal line adjacent thereto and disposed in a different layer from a layer of the outermost anode line, wherein the central anode line closest to a center position of the pixel driving circuit generates a smallest number of capacitors with respect to the corresponding metal line adjacent thereto and disposed in a different layer from a layer of the central anode line.

In accordance with some implementations of the first aspect of the present disclosure, the pixel driving circuit is configured to control a light emission operation of each of the plurality of light-emitting elements in a pulse width modulation manner.

In accordance with some implementations of the first aspect of the present disclosure, each of the plurality of light-emitting elements is include a micro light-emitting element.

In accordance with some implementations of the first aspect of the present disclosure, the pixel driving circuit is configured to control an application time of a light emission signal to each of the light-emitting elements based on a pulse width, wherein the pixel driving circuit is configured to apply one pulse signal having a pulse width varying from a minimum of 1 Gray to a maximum of 32 Gray.

In accordance with some implementations of the first aspect of the present disclosure, a first electrode is disposed under each of the plurality of light-emitting elements, wherein each of the light-emitting elements is electrically connected to the first electrode by eutectic bonding.

A second aspect of the present disclosure provides a display device comprising: a substrate; a pixel driving circuit disposed on the substrate; a plurality of light-emitting elements electrically connected to the pixel driving circuit, wherein the plurality of light-emitting elements and the pixel driving circuit are disposed in different layers; an optical insulating layer covering the plurality of light-emitting elements; a first electrode disposed under each of the plurality of light-emitting elements; a second electrode disposed on the plurality of light-emitting elements and the optical insulating layer; and a plurality of anode lines extending in a column direction and arranged in a row direction, wherein each of the anode line connects anode electrodes of light-emitting elements arranged so as to be adjacent to each other in the column direction among the plurality of light-emitting elements, wherein the plurality of anode lines are arranged so as to be spaced from each other by an equal spacing in the row direction, wherein the plurality of anode lines includes an outermost anode line spaced form the pixel driving circuit by a greatest spacing in the row direction, and an central anode line disposed at a central position of the pixel driving circuit, wherein each of the plurality of anode lines disposed from the outermost by the equal spacing in the row direction is repeatedly bent in a zigzag manner and extends along the column direction.

In accordance with some implementations of the second aspect of the present disclosure, the plurality of light-emitting elements includes a first light-emitting element emitting red light, a second light-emitting element emitting green light, and a third light-emitting element emitting blue light.

In accordance with some implementations of the second aspect of the present disclosure, the pixel driving circuit is configured to control the first light-emitting element to emit light, and then, the second light-emitting element to emit light.

In accordance with some implementations of the second aspect of the present disclosure, each of the light-emitting elements is bonded to the first electrode by a solder pattern.

In accordance with some implementations of the second aspect of the present disclosure, the first electrode is include a plurality of conductive layers, wherein the plurality of conductive layers include: a first conductive layer disposed on a bank; a second conductive layer disposed on the first conductive layer; a third conductive layer disposed on the second conductive layer; and a fourth conductive layer disposed on the third conductive layer.

In accordance with some implementations of the second aspect of the present disclosure, each of the plurality of light-emitting elements includes: an anode electrode disposed on the solder pattern; a first semiconductor layer disposed on the anode electrode; an active layer disposed on the first semiconductor layer; a second semiconductor layer disposed on the active layer; a cathode electrode disposed on the second semiconductor layer; and an encapsulation film disposed on at least a portion of each of the first semiconductor layer, the active layer, the second semiconductor layer, the anode electrode, and the cathode electrode.

In accordance with some implementations of the second aspect of the present disclosure, the optical insulating layer includes: a first optical layer disposed on the display area so as to surround each of the plurality of light-emitting elements; a second optical layer disposed on a passivation layer so as to surround the first optical layer in the display area; and a third optical layer disposed on the second electrode.

Although some implementations of the present disclosure have been described above with reference to the accompanying drawings, the present disclosure may not be limited to some implementations and may be implemented in various different forms. Those of ordinary skill in the technical field to which the present disclosure belongs will be able to appreciate that the present disclosure may be implemented in other specific forms without changing the technical idea or essential features of the present disclosure. Therefore, it should be understood that some implementations as described above are not restrictive but illustrative in all respects.

Subject matter of the present disclosure is also defined in the following clauses:
Clause 1. A display device comprising:
   a substrate including a display area and a non-display area;
   a pixel driving circuit disposed on the substrate in the display area;
   a plurality of light-emitting elements electrically connected to the pixel driving circuit; and
   a plurality of anode lines extending in a column direction and arranged in a row direction, wherein each of the plurality of anode lines connects anode electrodes of light-emitting elements arranged so as to be adjacent to each other in the column direction among the plurality of light-emitting elements,
   wherein each of some of the plurality of anode lines spaced apart from the pixel driving circuit by a predetermined distance in the row direction is repeatedly bent in a zigzag manner and extends along the column direction.
Clause 2. The display device of clause 1, wherein the plurality of anode lines are arranged so as to be spaced from an outermost of the substrate to a center position of the pixel driving circuit by an equal spacing in the row direction.
Clause 3. The display device of clause 2, wherein the pixel driving circuit is spaced from the outermost by a greatest spacing distance in the row direction.
Clause 4. The display device of clause 2 or clause 3, wherein each of the plurality of anode lines has the same capacitance value from the center anode line arranged in the center position of the pixel driving circuit to the outermost anode line arranged in the outermost of the substrate.
Clause 5. The display device of any preceding clause, wherein some of the plurality of anode lines overlapping the bent anode lines adjacent to each other along the column direction are disposed in different layers from the bent anode lines.
Clause 6. The display device of clause 5, wherein each of the anode lines disposed in the same layer among the plurality of anode lines arranged so as to be spaced from each other by the equal spacing in the row direction is repeatedly bent in the zigzag manner and extends along the column direction.
Clause 7. The display device of clause 6, wherein each of the bent anode lines and a metal line form a capacitor when the bent anode line overlaps the metal line of another layer that is adjacent to each other in the row direction.
Clause 8. The display device of any preceding clause, wherein a number of bent times of the bent anode lines increases from a center position of the pixel driving circuit to the outermost of the substrate.
Clause 9. The display device of clause 8, wherein among the bent anode lines, the outermost anode line generates a largest number of capacitors with respect to the corresponding metal line adjacent thereto and disposed in a different layer from a layer of the outermost anode line.
Clause 10. The display device of clause 9, wherein the central anode line closest to a center position of the pixel driving circuit generates a smallest number of capacitors with respect to the corresponding metal line adjacent thereto and disposed in a different layer from a layer of the central anode line.
Clause 11. The display device of any preceding clause, wherein the pixel driving circuit is configured to control an application time of a light emission signal to each of the light-emitting elements based on a pulse width,
Clause 12. The display device of clause 11, wherein the pixel driving circuit is configured to apply one pulse signal having a pulse width varying from a minimum of 1 Gray to a maximum of 32 Gray.
Clause 13. The display device of any preceding clause, wherein a first electrode is disposed under each of the plurality of light-emitting elements.
Clause 14. The display device of clause 13, wherein each of the light-emitting elements is electrically connected to the first electrode by eutectic bonding.
Clause 15. A display device comprising:
   a substrate;
   a pixel driving circuit disposed on the substrate;
   a plurality of light-emitting elements electrically connected to the pixel driving circuit, wherein the plurality of light-emitting elements and the pixel driving circuit are disposed in different layers;
   an optical insulating layer covering the plurality of light-emitting elements;
   a first electrode disposed under each of the plurality of light-emitting elements;
   a second electrode disposed on the plurality of light-emitting elements and the optical insulating layer; and
   a plurality of anode lines extending in a column direction and arranged in a row direction, wherein each of the plurality of anode lines connects anode electrodes of light-emitting elements arranged so as to be adjacent to each other in the column direction among the plurality of light-emitting elements,
   wherein the plurality of anode lines are arranged so as to be spaced from each other by an equal spacing in the row direction, wherein the plurality of anode lines include an outermost anode line spaced from the pixel driving circuit by a greatest spacing in the row direction, and a central anode line disposed at a central position of the pixel driving circuit,
   wherein each of the plurality of anode lines disposed from the outermost by the equal spacing in the row direction is repeatedly bent in a zigzag manner and extends along the column direction.
Clause 16. The display device of clause 15, wherein the plurality of light-emitting elements include a first light-emitting element emitting red light, a second light-emitting element emitting green light, and a third light-emitting element emitting blue light.
Clause 17. The display device of clause 16, wherein the pixel driving circuit is configured to control the first light-emitting element to emit light, and then, the second light-emitting element to emit light.
Clause 18. The display device of any one of clauses 15 to 17, wherein each of the plurality of light-emitting elements is bonded to the first electrode by a solder pattern.
Clause 19. The display device of any one of clauses 15 to 18, wherein the first electrode include a plurality of conductive layers,
   wherein the plurality of conductive layers include:
   a first conductive layer disposed on a bank;
   a second conductive layer disposed on the first conductive layer;
   a third conductive layer disposed on the second conductive layer; and
   a fourth conductive layer disposed on the third conductive layer.
Clause 20. The display device of clause 18, wherein each of the plurality of light-emitting elements includes:
   an anode electrode disposed on the solder pattern;
   a first semiconductor layer disposed on the anode electrode;
   an active layer disposed on the first semiconductor layer;
   a second semiconductor layer disposed on the active layer;
   a cathode electrode disposed on the second semiconductor layer; and
   an encapsulation film disposed on at least a portion of each of the first semiconductor layer, the active layer, the second semiconductor layer, the anode electrode, and the cathode electrode.
Clause 21. A display device comprising:
   a display panel including a display area and a non-display area;
   wherein the display panel comprises:
      a pixel driving circuit disposed in the display area;
      a plurality of light-emitting elements electrically connected to the pixel driving circuit; and
      a plurality of anode lines extending in a column direction and arranged in a row direction;
   wherein each of the plurality of anode lines connects anode electrodes of light-emitting elements adjacent to the anode line in the column direction among the plurality of light-emitting elements; and
   each of some of the plurality of anode lines, spaced apart from the pixel driving circuit in the row direction comprises a plurality of segments, each segment comprising a bending segment bent to the row direction, and an extending segment extending along the column direction and directly connected to the bending segment.
Clause 22. The display device of clause 21, wherein two neighboring segments of the plurality of segments are connected to each other such that the anode line extends along the column direction.
Clause 23. The display device of clause 22, wherein a first bending segment of a first segment in the two neighboring segments is bent in the row direction such that a second extension segment, of a second segment in the two neighboring segments, connected to the first bending segment overlaps with a metal line of a neighbor layer.

## Claims

1. A display device comprising:
a substrate including a display area and a non-display area;
a pixel driving circuit disposed on the substrate in the display area;
a plurality of light-emitting elements electrically connected to the pixel driving circuit; and
a plurality of anode lines extending in a column direction and arranged in a row direction, wherein each of the plurality of anode lines connects anode electrodes of light-emitting elements arranged so as to be adjacent to each other in the column direction among the plurality of light-emitting elements,
wherein each of some of the plurality of anode lines spaced apart from the pixel driving circuit by a predetermined distance in the row direction is repeatedly bent in a zigzag manner and extends along the column direction.

2. The display device of claim 1, wherein the plurality of anode lines are arranged so as to be spaced from an outermost of the substrate to a center position of the pixel driving circuit by an equal spacing in the row direction.

3. The display device of claim 2, wherein the pixel driving circuit is spaced from the outermost by a greatest spacing distance in the row direction.

4. The display device of claim 2 or claim 3, wherein each of the plurality of anode lines has the same capacitance value from the center anode line arranged in the center position of the pixel driving circuit to the outermost anode line arranged in the outermost of the substrate.

5. The display device of any preceding claim, wherein some of the plurality of anode lines overlapping the bent anode lines adjacent to each other along the column direction are disposed in different layers from the bent anode lines.

6. The display device of claim 5, wherein each of the anode lines disposed in the same layer among the plurality of anode lines arranged so as to be spaced from each other by the equal spacing in the row direction is repeatedly bent in the zigzag manner and extends along the column direction.

7. The display device of claim 6, wherein each of the bent anode lines and a metal line form a capacitor when the bent anode line overlaps the metal line of another layer that is adjacent to each other in the row direction.

8. The display device of any preceding claim, wherein a number of bent times of the bent anode lines increases from a center position of the pixel driving circuit to the outermost of the substrate.

9. The display device of claim 8, wherein among the bent anode lines, the outermost anode line generates a largest number of capacitors with respect to the corresponding metal line adjacent thereto and disposed in a different layer from a layer of the outermost anode line.

10. The display device of claim 9, wherein the central anode line closest to a center position of the pixel driving circuit generates a smallest number of capacitors with respect to the corresponding metal line adjacent thereto and disposed in a different layer from a layer of the central anode line.

11. The display device of any preceding claim, wherein the pixel driving circuit is configured to control an application time of a light emission signal to each of the light-emitting elements based on a pulse width.

12. The display device of claim 11, wherein the pixel driving circuit is configured to apply one pulse signal having a pulse width varying from a minimum of 1 Gray to a maximum of 32 Gray.

13. The display device of any preceding claim, wherein a first electrode is disposed under each of the plurality of light-emitting elements.

14. The display device of claim 13, wherein each of the light-emitting elements is electrically connected to the first electrode by eutectic bonding.
